(19) Europäisches Patentamt
European Patent Office
Office européen des brevets

(11) **EP 4 254 690 A1**

(12) **EUROPEAN PATENT APPLICATION**

(43) Date of publication:
**04.10.2023 Bulletin 2023/40**

(21) Application number: **22166290.1**

(22) Date of filing: **01.04.2022**

(51) International Patent Classification (IPC):
*H01S 5/34* (2006.01)     *H01S 5/10* (2021.01)
*H01S 5/028* (2006.01)     *H01S 5/00* (2006.01)

(52) Cooperative Patent Classification (CPC):
**H01S 5/3402; H01S 5/028; H01S 5/0287;**
**H01S 5/1039;** H01S 5/0035; H01S 5/0288;
H01S 5/3422; H01S 2301/163

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **ETH Zurich**
**8092 Zurich (CH)**

(72) Inventors:
• **FAIST, Jérôme**
  **8052 Zürich (CH)**
• **KAPSALIDIS, Filippos**
  **8051 Zürich (CH)**
• **WANG, Zhixin**
  **8906 Bonstetten (CH)**
• **STARK, David**
  **9230 Flawil (CH)**
• **WANG, Ruijun**
  **510275 Guangzhou (CN)**

(54) **CASCADE LASERS**

(57)     A single-mode cascade laser (1) that will lase at a pre-specified lasing wavelength and how to manufacture such a laser. A buried-heterostructure waveguide (5) is terminated to a precisely specified length of $\leq 100$ $\mu$m by dry etching its end facets (36, 38). A cavity end mirror is formed on each end facet by depositing first and second optical material layers (24, 26) with differing refractive indices, wherein each mirror layer has a thickness in a range above and below one-quarter of the intended lasing wavelength within the optical material from which the mirror layer is formed. The precise definition of the length of the waveguide and of the thicknesses of the end mirror layers together with the short waveguide length, which is shorter than what is achievable by mechanical cleaving, provide a Fabry-Perot cavity that supports single-mode lasing at the specified lasing wavelength.

FIG. 4B

**Description**

**BACKGROUND OF THE INVENTION**

The invention relates to cascade lasers.

Cascade laser is a generic term for quantum cascade laser (QCL) and interband cascade laser (ICL), wherein the former is based on cascading intraband transitions between subbands of quantum wells in a Type I superlattice structure, whereas the latter is based on cascading interband transitions between subbands of quantum wells in a Type II (or sometimes Type I) superlattice structure. Cascade lasers emit in the infrared, with QCLs having been demonstrated with emission wavelengths from 2.6 $\mu$m up to 250 $\mu$m. QCLs are in much more widespread use than ICLs, so the following summary of the prior art is exclusively concerned with QCLs.

Commercially available QCLs are based on an edge-emitting structure similar to the structure of a standard edge-emitting laser diode. In an edge-emitting laser diode the laser emission is lateral in relation to the semiconductor heterostructure stack. An opposed mutually parallel pair of cleaved facets form a Fabry-Perot cavity, i.e. the cavity length is defined by the separation between the two end facets. One cleaved facet acts as a back reflector and the other as an output coupler. Without other measures, an edge-emitting laser diode will have multi-mode emission, i.e. multiple longitudinal modes will be capable of lasing and, depending on the conditions, a certain number of these will lase simultaneously.

To provide single-mode emission, an in-plane grating is fabricated along the waveguiding layer. This may be done by fabricating an in-line grating along the same portion of the waveguiding layer where gain occurs, i.e. where carriers are injected, such lasers being called distributed feedback (DFB) lasers. Another way to provide single-mode emission is to provide an in-plane grating at one end of the waveguiding layer away from the injection region to provide a back reflector, such a mirror being called a distributed Bragg reflector (DBR) and the laser a DBR laser. QCL types are known that follow these edge-emitting diode laser design types in a one-to-one analogy, i.e. cleaved facet multimode QCL, single mode DFB QCL and single mode DBR QCL.

Wang *et al.* [9] discloses an edge-emitting single mode DFB QCL based on a buried-heterostructure design with an emission wavelength of 4.3 $\mu$m. The cavity is defined by mechanical cleaving to achieve a cavity length of around 250 $\mu$m. The cleaved end facets are coated with high-reflectivity metal (Au) coatings. On the output coupler facet, the gold coating has a circular hole patterned by focused ion beam milling with a diameter of around 950 nm which corrects the phase front and thereby reduces diffraction losses.

While cleaved facet edge-emitting QCLs are generally multimode, single-mode emission has been demonstrated by shortening the cavity length.

Cendejas et al. [6] fabricated a single-mode edge-emitting QCL based on a ridge waveguide design. A short Fabry-Perot cavity length was achieved by a special wafer cleaving process in which the substrate was thinned down to a thickness of only 80 $\mu$m before cleaving. This made it possible to fabricate QCLs with cavity lengths between 764 $\mu$m and 110 $\mu$m. The high mirror losses associated with as-cleaved short cavities was mitigated by evaporating high-reflectivity metallic coatings onto the cleaved end facets to provide back and front facet reflectivities of 0.95 and 0.75 respectively. The cleaving process used to define the cavity length is however not accurate enough to obtain a specific cavity length with the precision needed to match the laser emission wavelength to an absorption transition of a particular gas molecule species of interest, as would be required for a QCL that is to be used in a gas sensor.

Hofling et al. [7] discloses edge-emitting DBR QCLs based on a ridge waveguide with monolithically integrated Bragg mirrors. Fabrication proceeds with a first fabrication step to define a ridge waveguide in the wafer by optical lithography and lift-off. In a second step, the Bragg (DBR) mirrors are defined by electron beam lithography and lift off. In a third step pattern transfer is performed in a single etch step by a dry etching technique and removal of the nickel, which serves as the etch mask. QCLs with cavity lengths in the range 1000 $\mu$m to 98 $\mu$m were fabricated, including several with cavity lengths around 100 $\mu$m, i.e. 98, 99, 100, 101 and 105 $\mu$m. While single mode operation was observed for drive currents just above threshold, at higher drive currents the QCLs lased multimode and therefore the device cannot be considered to operate in single mode for most relevant applications. Moreover, it was observed that the maximum operating temperature decreases with decreasing cavity length. While room temperature operation was achieved with a laser of cavity length of 800 $\mu$m, with a laser of cavity length 100 $\mu$m operation was only possible up to 260 K. The operating temperature limitation was attributed to the Bragg reflectors having a maximum possible reflectivity, R, of about 80% and to the diffraction losses of the Bragg mirrors [7, 8].

While as described above, edge-emitting QCLs can be designed largely following design principles familiar from conventional edge-emitting laser diodes, this one-to-one analogy breaks down in the case of the vertical cavity surface-emitting laser (VCSEL). A conventional VCSEL geometry using DBRs cannot be used to realize a QCL because polarization selection rules in a QCL mean that intraband transitions involving vertically travelling photons provide no gain. A straightforward implementation of a vertical cavity surface-emitting QCL in one-to-one analogy with a VCSEL is therefore not possible. The electric field of the light generated in a QCL is always polarized in the growth direction, so only gain in the TM mode is possible.

Several different vertical emission QCL designs are however known in the literature [1-5, 18]. These all work around the polarization selection rules by using an in-plane waveguide mode for lasing combined with a second order grating or other means to couple out a portion of the laser radiation vertically. In other words, the cavity remains horizontal, but the emission is nevertheless vertical or at least with a vertical component.

For example, Süess *et al*/2016 [1] discloses a surface-emitting QCL based on a linear ridge waveguide. End mirrors are formed by respective first order grating DBR structures fabricated at each end of the ridge waveguide, the periodicity of the first order gratings also providing mode selection. In addition, for vertical outcoupling, a second order grating is fabricated in the manner of a DFB structure on top of the ridge waveguide. The second order grating refracts a portion of the light from the lasing mode out of the waveguide in the vertical direction to provide for vertical outcoupling and so emission from the top surface of the chip. Several other publications [2-5] disclose surface-emitting QCLs based on rings or disks.

## SUMMARY OF THE INVENTION

According to one aspect of the invention, there is provided a single-mode cascade laser with a lasing wavelength, for example one that lies in the wavelength range 2 to 20 micrometers, the laser comprising:

a plurality of semiconductor layers collectively forming an active region where gain can occur across a gain bandwidth that includes the lasing wavelength;
a waveguide encompassing the active region and terminating in first and second end facets; and
respective end mirrors formed on the end facets of the waveguide, each end mirror comprising a layer of a first optical material formed on its respective waveguide end facet and a layer of a second optical material formed on the first optical material layer, the first and second optical materials having different refractive indices at the lasing wavelength,
wherein the waveguide and the end mirrors collectively form a Fabry-Perot cavity with a cavity length that provides a longitudinal mode in the waveguide with an energy at the lasing wavelength,
wherein the end mirrors both have a reflectivity of at least 90% for the lasing longitudinal mode, and
wherein the cavity length is equal to or less than 100 micrometres.

According to another aspect of the invention, there is provided a method of manufacturing a single-mode cascade laser that will operate with a specified lasing wavelength $\lambda$, the specified lasing wavelength lying, for example, in the wavelength range 2 to 20 micrometers, the method comprising:

providing a semiconductor wafer with a plurality of semiconductor layers collectively forming an active region where gain can occur across a gain bandwidth that includes the specified lasing wavelength;
fabricating a waveguide that encompasses the active region;
fabricating first and second end facets for the waveguide by dry etching so that the waveguide has a length equal to a specified physical length $L_{phys}$;
forming respective end mirrors on the waveguide end facets, the end mirrors having respective effective thicknesses $L_{coat1}$, $L_{coat2}$, each end mirror comprising a layer of a first optical material formed on its respective waveguide end facet and a layer of a second optical material formed on the first optical material layer, the first and second optical materials having different refractive indices at the specified lasing wavelength, wherein the first and second end mirrors each provide a reflectivity of at least 90% for the lasing longitudinal mode,
wherein the waveguide and end mirrors collectively form a Fabry-Perot cavity with a cavity length expressed by the formula

$$L_{tot} = L_{phys} \cdot n_{refr} + L_{coat1} + L_{coat2} = q \cdot \frac{\lambda}{2},$$

where $q$ is an integer and $n_{refr}$ is the effective refractive index of the waveguide at the specified lasing wavelength, and wherein the cavity length is equal to or less than 100 micrometres.

According to a further aspect of the invention, there is provided a method of computing a set of parameter values for manufacturing a single-mode cascade laser that will lase at a specified lasing wavelength $\lambda$, the specified lasing wavelength lying, for example, in the wavelength range 2 to 20 micrometers, the method comprising:

receiving as input specifications for a semiconductor wafer with a plurality of semiconductor layers collectively forming an active region where gain can occur across a gain bandwidth that includes the specified lasing wavelength; receiving as input specifications for a waveguide that encompasses the active region including a value for the effective refractive index $n_{refr}$ of the waveguide at the specified lasing wavelength;

selecting a cavity length for a Fabry-Perot cavity that complies with the formula

$$L_{tot} = q \cdot \frac{\lambda}{2},$$

where q is an integer and which is equal to or less than 100 micrometres;

determining respective effective thicknesses $L_{coat1}$, $L_{coat2}$ for for respective end mirrors, each end mirror comprising a layer of a first optical material formed on its respective waveguide end facet and a layer of a second optical material formed on the first optical material layer, the first and second optical materials having different refractive indices at the lasing wavelength;

determining a physical length $L_{phys}$ for the waveguide according to the formula

$$L_{tot} = L_{phys} \cdot n_{refr} + L_{coat1} + L_{coat2} = q \cdot \frac{\lambda}{2} \quad ;$$

and

outputting as the set of parameters values the determined physical length $L_{phys}$ of the waveguide and the determined effective thicknesses $L_{coat1}$, $L_{coat2}$ for the end mirrors.

Cascade lasers embodying the invention may be a quantum cascade laser or an interband cascade laser.

A particularly important area of application for cascade lasers according to the invention is in gas sensors. For a gas sensor, the laser must emit at the wavelength of a particular absorption line of the gas to be sensed. The manufacturing process therefore needs to produce lasers that emit at the specified wavelength plus/minus half the tuning range that can be achieved through drive current variation (and/or temperature variation). Our proposed approach is highly commercially significant, since it allows a specified emission wavelength to be precisely met.

With current technology, cascade laser yield is low for gas sensor applications, since a high proportion of the cascade lasers that are fabricated do not emit close enough to the specified emission wavelength to be useable. In addition to gas spectroscopic sensing, other specific applications where cascade lasers according to the invention could be used are free space communication and LIDAR.

The length of the waveguide is by far the largest component of the total cavity length. Therefore, to manufacture a single-mode cascade laser that emits at a specified lasing wavelength, e.g. matched to a particular gas molecule transition, it is necessary to have precise control of the fabrication process used to define the waveguide length. This can be achieved by using dry etching to form the first and second end facets. The mirror layers are then deposited on their associated end facet as coatings. Dry etching also allows the end facets to be located much closer together than is possible with cleaving. As explained in more detail below, for single mode operation of the cascade laser at room temperature the cavity length (and hence waveguide length) must be sufficiently small to ensure that neighbouring longitudinal modes in the waveguide do not experience significant gain and, specifically, do not attain lasing threshold. For this reason, cavity (or waveguide) lengths of interest are generally 100 $\mu$m or less. In some embodiments, the cavity length is equal to or less than one of 90, 80, 70, 60 and 50 micrometres. In some embodiments, the cavity length is less than one of 100, 90, 80, 70 and 60 micrometres and more than one of 10, 20, 30, 40 and 50 micrometres. The use of dry etching allows a waveguide to be defined with a short length and a precise length, which in turn enables a single mode cascade laser to be manufactured that emits at a (pre-)specified emission wavelength, e.g. matched to a particular absorption transition in a particular gas molecule species. This is not possible with a mechanical cleaving process, since waveguide lengths of less than about 100 micrometers are not mechanically achievable and since the location of the crystallographic plane along which a wafer breaks when cleaving is in any case subject to some randomness. Dry etching is used to fabricate a laser with a cavity length that is sufficiently small that the cavity length will only support one mode for lasing, i.e. the mode spacing defined by the cavity length is comparable to or greater than the gain bandwidth of the gain medium. This differs fundamentally from the approach for mode selection in cascade lasers that use DFB or DBR designs.

Having a shorter cavity length also results in the wafer area per laser device being smaller so that a greater number of devices per wafer can be manufactured. In addition, since the end facets are produced during fabrication with dry etching rather than post fabrication by mechanical cleaving, significant cost reductions can be expected. This is in relation not only to the fact that the end facets are produced on the wafer by dry etching but also since the mirror coatings on the end facets can also be produced on the wafer before dicing. If the end facets are formed by cleaving, any mirror coatings must by definition be applied after the wafer has been broken up by cleaving into the individual chips. There is thus potential for significantly reducing the unit cost, so that cascade lasers can truly become mass market devices.

The shorter cavity length also results in lower power consumption. This is because power consumption scales approximately linearly with the volume of the gain medium, i.e. how many carriers are injected. The low power consumption makes our design suited to battery-powered operation. Cascade lasers can therefore be incorporated in low power sensor devices as highly sensitive infrared detectors. Such devices may additionally include other ancillary components for an Internet of Things (IoT) sensor, e.g. low power wireless transceivers, low power memory etc. It will also be possible to incoporate sensor devices in battery-powered, portable computing devices such as hand-held devices (e.g. smartphones, tablets) and wearable devices (e.g. augmented reality glasses, functional clothing for workers in hazardous environments).

Single mode operation and what constitutes a single mode laser within the scope of the invention may be defined in several ways. For example, one definition is that, when operating at an optical output power of one of 0.5 mW and 1 mW, the laser has a side-mode suppression ratio of greater than 30 decibels. Another definition is that, when operating at an optical output power of one of 0.5 mW and 1 mW, the longitudinal mode at the lasing wavelength is the only waveguide mode that lases. This topic is further discussed below.

As mentioned above, each end mirror is made of mirror layers of first and second optical materials with different refractive indices. The first and second optical materials are selected to have different refractive indices, i.e. to provide a refractive index contrast large enough (e.g. $\Delta n > 1$) such that only a small number of pairs of mirror layers (e.g. 1, 2, 3, 4 or 5 pairs) are sufficient for achieving a specified reflectivity; typically of at least 90%.

In some embodiments, one or both of the end mirrors may be made with the first optical material being a dielectric and the second optical material being a metal. For example, there may be only one dielectric layer and one metal layer and the dielectric layer has a thickness of between 0.2 and 1.3 times one-quarter of the lasing wavelength within the first optical material, more particularly between 0.3 and 1.2 times one-quarter of the lasing wavelength within the first optical material. If the end mirror is formed from only one dielectric layer and one metal layer, the metal layer thickness is not critical. The dielectric material is selected in part based on the deposition method used. For example, with PECVD, $Si_3N_4$ or $SiO_2$ are suitable dielectric materials. Using electron beam evaporation, a suitable dielectric material is $Al_2O_3$. The selection of dielectric material also depends on the emission wavelength of the laser. The dielectric material should have a low refractive index (<2) and reasonable transparency in the wavelength of interest. The metal for the metallic coating layer may be selected from high conductivity metals including silver, gold and copper. An additional thin adhesion coating from materials such as Titanium or Chromium may be applied before depositing the metal, e.g. having a thickness of only a few nanometres. The high reflectivity end mirror design is then based on a dielectric layer formed on the end facet and a metallic layer formed on the dielectric layer (and optionally one or more repeats), the dielectric-metal layering providing low diffraction loss for the lasing mode in the cavity and hence increased effective reflectivity.

In other embodiments, one or both of the end mirrors may be made with first and second optical materials that are both dielectric materials but of course different ones to provide different refractive indices at the lasing wavelength. In other words, as an alternative to a dielectric-metal material pairing for the first and second optical materials, a material pairing of two dielectric materials with a large refractive index difference can be used, the dielectric material with the lower refractive index taking the place of the metal. One dielectric-dielectric materials' combination is $Al_2O_3$ and Ge. Another is $Al_2O_3$ and Si. The high reflectivity end mirror design is then based on a layer of a first dielectric material formed on the end facet and a layer of a second dielectric formed on the dielectric layer (and optionally one or more repeats), the dielectric-dielectric layering providing low diffraction loss for the lasing mode in the cavity and hence increased effective reflectivity. Such an end mirror may comprise 2, 3, 4 or more repeats of the two dielectric layers, each layer type having a thickness of between 0.7 and 1.3 times one-quarter of the lasing wavelength within the first and second optical materials, more particularly between 0.8 and 1.2 times.

Good manufacturing control of the process used to deposit each mirror layer is possible with plasma deposition (PECVD). Electron beam evaporation is another suitable method. It is noted that the respective thicknesses of the mirror layers on the two end facets $L_{coat1,2}$ also needs to be included for the cavity length in order that the laser's specified emission wavelength is achieved by the fabrication process.

The cavity end mirrors can be manufactured which provide a reflectivity of 90% or more for the lasing longitudinal mode, where the reflectivity is for the lasing longitudinal mode. In particular, end mirrors can be manufactured which provide a reflectivity of at least one of: 91%, 92%, 93%, 94%, 95%, 96%, 97% and 98% for the lasing longitudinal mode.

The minimum requirement for an end mirror according to this design is thus to have one dielectric material layer formed on the as-etched end facet followed by one metal material (or other dielectric material) layer deposited on the dielectric layer.

To achieve the lowest possible losses by reflection, i.e. the highest reflectivity, as desired in order to make such short cavity devices capable of lasing efficiently at room temperature, it is beneficial not only to consider the simple reflectivity of the coatings on the end facets but also the diffraction losses of reflection from the end facets. One way of reducing diffraction losses is to design the waveguide so that the lasing longitudinal mode has a Gaussian or near-Gaussian profile, e.g. with a deviation from Gaussian of less than 2%, more preferably less than 1%. The mode profile can be quantified by computing the mean deviation of the electric field in growth direction to its Gaussian fit. The mode profile $E_z(x,z)$ of the waveguide cross-section is considered along the vertical ($x = 0, z$) and horizontal direction ($x, z = 0$) respectively, where the origin is the center of the waveguide core. The mean deviations can then be written as

$$M_{vertical} = \frac{1}{n}\sum_i \left| E_z(0, z_i) - g_{fit}\big(E_z(0, z_i)\big)\right| \qquad \text{(X1)}$$

$$M_{horizontal} = \frac{1}{n}\sum_i \left| E_z(x_i, 0) - g_{fit}\big(E_z(x_i, 0)\big)\right|. \qquad \text{(X2)}$$

The Gaussian fitting function is

$$g_{fit}(x) = a \cdot \exp\left(-\left(\frac{x - b}{c}\right)^2\right), \qquad \text{(X3)}$$

where *a* is the amplitude, *b* the centroid and c relates to the peak width. Significant improvement in the reflectivity is found when the waveguide is made such that these errors are then smaller than 1% or 2%.

Cascade lasers embodying the invention may be surface-emitting or edge-emitting.

For surface-emitting embodiments, a surface extractor component is provided for coupling out light at the lasing wavelength, i.e. laser light, out of the plane of the waveguide. The coupling out is performed from an intermediate portion of the waveguide that is situated away from the end facets. In surface-emitting embodiments neither cavity end mirror is involved in outcoupling, so they can both be optimized for highest achievable reflectivity (e.g. at least 95, 96, 97 or 98% for the lasing mode).

For surface-emitting embodiments, the top electrode used for current injection may have an aperture to allow passage of the laser beam out of the laser without having to pass through it, e.g. an aperture that allows transmission of the output beam tapped out by the surface extractor component. Alternatively, a transparent 'blanket' top electrode may be provided, e.g. a thin degeneratively doped semiconductor layer.

For surface-emitting embodiments, there are various options for the surface extractor component used for coupling out the laser light.

A first option for surface out-coupling is to provide the surface extractor component in the form of a higher order Bragg grating that is formed along a portion of the waveguide, such as at or near the middle of the cavity length. Laser light may then be coupled out either upwards through the top surface of the epitaxial structure or downwards through the substrate. The laser light may escape upwards through an aperture on the top metallic ohmic contact. Alternatively, for emission through the substrate, the substrate may be made of a material that is transparent at the lasing wavelength or may be etched away under the laser structure to provide an output aperture. An example of a suitable higher order grating is disclosed in Jouy et al [12]. Specifically, the upper or lower cladding layer is structured to define a higher order grating that serves to couple out a component of the lasing light from the active region layers as the laser beam, the higher order grating being of order m in respect of the lasing wavelength, $\lambda$, where m is at least 2. In some embodiments, the higher order grating is of order m = 2, i.e. a second order grating. In other embodiments, the higher order grating may be of order m = 3, 4 or more. By 'higher order' in this document we mean $m \geq 2$. The higher order grating may incorporate a phase-shift, such as a $\pi$-shift, to affect the output beam profile. A higher order grating for surface out-coupling can be formed by suitable lithography processes, in particular photolithography, optionally in combination with semiconductor overgrowth. The processing steps may involve etching, for example with wet or dry etching processes. Etching may be combined with subsequent overgrowth or other filling. Specifically, a grating may be formed by etching a semiconductor layer with a periodic surface patterning to form trenches and then filling the trenches with a suitable semiconductor material or metal (or metallic) material to provide the necessary in-plane refractive index contrast. To define a mask for the grating, UV or deep-UV lithography may be used, or alternatively e-beam lithography. The etch may be wet or dry, e.g. by reactive ion etching. For embodiments that have semiconductor-semiconductor gratings, more fabrication details can be found in Kapsalidis et al 2018 [16]. For embodiments that have semiconductor-metal gratings, more fabrication details can be found in Wu et al 2017 [17]. It is noted that the purpose of the higher order Bragg grating is solely for the extraction, i.e. outcoupling, of light from the cavity. The higher order Bragg grating plays no role in the mode selection, mode selection being determined by the cavity length as formed by the waveguide and its end mirrors.

A second option for surface out-coupling is to use a 2D photonic crystal as described in Wang et al [13] and US 2009/147818 A1 [14].

A third option for surface out-coupling is to use an angled facet as reported by Slivken et al [15].

The higher order grating or other surface extractor component provided for the vertical or surface out-coupling couples out a component of the lasing mode to form an output beam that propagates either in the vertical direction or with a component of its trajectory in the vertical direction. The emission may not be precisely vertical emission and may be emission of an output beam from the surface or substrate that propagates at an angle to the semiconductor growth direction, i.e. has a vertical component.

For edge-emitting embodiments, the first end mirror provides a reflectivity for the lasing longitudinal mode that is at least 5% lower than that of the second end mirror, the first end mirror operating as an output coupler for edge emission of laser light and the second end mirror operating as a rear reflector. The rear reflector preferably has the highest achievable reflectivity (e.g. at least 95, 96, 97, 98% or more). The output coupler has a lower reflectivity, but still at least 85% (e.g. at least 86, 87, 88, 89, 90, 91, 92 or 93%). Alternatively, a non-standard output coupler design could also be used. One non-standard output coupler design is when the first end mirror incorporates an aperture having a diameter less than the lasing wavelength, as disclosed in Wang et al [9]. The aperture is transmissive to the lasing mode, i.e. non-reflecting, and the remaining area of the output coupling end facet is provided with an end mirror having the highest achievable reflectivity (e.g. 95, 96, 97, 98% or more).

## BRIEF DESCRIPTION OF THE DRAWINGS

This invention will now be further described, by way of example only, with reference to the accompanying drawings.

Figure 1 is a graph plotting gain margin ratio in percent as a function of cavity length in micrometers for a Lorentzian lineshape with full width at half maximum of 160 reciprocal centimeters.The selection of discrete points corresponds to Table 1 below.

Figure 2 is a graph plotting mirror losses in reciprocal centimeters as function of cavity length in micrometers for a mirror with a reflectivity of 97%. The selection of discrete points corresponds to Table 1 below.

Figure 3 plots the gain normalized to its peak gain against wavenumbers, assuming a Lorentzian lineshape with full width at half maximum of 160 reciprocal centimeters (grey shaded area). The upper and lower plot show the resonator modes for two different cavity lengths.

Figures 4A to 4C are three orthogonal schematic views of a QCL according to an embodiment of the invention; Figure 4A is a plan view; Figures 4B and 4C are parallel and perpendicular sections along the lines shown in Figure 4A.

Figure 5A is a more detail schematic of the same section as shown in Figure 4B.

Figure 5B is a more detail schematic of the same section as shown in Figure 4C.

Figures 6A to 6F are SEM images of example structures.

Figures 7A and 7B are graphs plotting modelling results for example dielectric-metal end mirror designs.

Figures 8A, 8B and 8C are graphs plotting modelling results for example dielectric-dielectric end mirror designs.

Figure 9 shows a section similar to Figure 5A for an alternative QCL with a different formation of the lower contact.

Figures 10A and 10B are parallel and perpendicular sections of an ICL embodiment comparable with the QCL sections of Figures 5A and 5B.

Figure 11 is a schematic drawing of an example gas sensor based on laser absorption spectroscopy in a linear, transmission configuration.

Figure 12 is a schematic drawing of an example gas sensor based on laser absorption spectroscopy with the laser emitter and detectors in a planar, reflection configuration.

Figure 13 is a schematic drawing of an example gas sensor based on photoacoustic spectroscopy with the laser emitter and the acoustic detector in a planar configuration.

## DETAILED DESCRIPTION

### SINGLE MODE DEFINITIONS

A suitable definition of single mode operation and what constitutes a single mode cascade laser can be made in terms of the laser's side-mode suppression ratio (SMSR). The SMSR as a parameter takes account of the fact that not all the power resides in the principal lasing mode, i.e. there is in general non-zero power in the neighbouring longitudinal modes. A cascade laser's side-mode suppression ratio (SMSR) describes the optical power ratio in decibels between the power of the main lasing mode and the power of the next most powerful mode. The next most powerful mode may or may not be lasing. The next most powerful mode in our designs will almost always be one of the two nearest neighbour longitudinal modes. A suitable definition of single mode operation is when SMSR > 30 dB, indicating that there is at least 1000 times more power in the main lasing mode as in the next most powerful mode. Since the SMSR will tend to reduce with increasing drive current above threshold, a further definition for what constitutes a single mode laser is a laser that has single mode operation, i.e. SMSR > 30 dB, under usual operating conditions, i.e. at usual operating drive currents, which will be significantly above the lasing threshold. For example, we may define a single mode cascade laser according to one or more embodiments of the invention as a cascade laser that has a SMSR > 30 dB at an optical output power of 0.5 mW or 1 mW. An alternative definition of a single mode cascade laser according to one or more embodiments of the invention is a cascade laser in which only the longitudinal mode at the lasing wavelength lases when operating at an optical output power of 0.5 mW or 1 mW.

### PARAMETER SPACE DISCUSSION

The dry etching approach enables the cavity length of the laser to be precisely defined so that the laser will operate in single mode at a very specific pre-defined wavelength $\lambda$. High precision of the wavelength selection is critical for gas sensors, for example, where the emission wavelength must be matched to a particular molecular transition. After choosing a suitable integer q, the wavelength $\lambda$ is then achieved by constructing the device with a well-defined optical length computed as the sum,

$$L_{tot} = L_{opt,cav} + L_{coat1} + L_{coat2} = L_{phys} \cdot n_{refr} + L_{coat1} + L_{coat2} = q \cdot \frac{\lambda}{2}, \qquad (1)$$

where $L_{phy}$ is the geometrical length of the cavity (i.e. dry-etched mesa) and $n_{refr}$ is the effective index of the waveguide and $L_{coat1}$, $L_{coat2}$ are the thicknesses of the first and second end mirrors. In other words, the cavity length needs to take account of the thicknesses of the end mirror coating layers, not only the as-etched distance between the end facets of the semiconductor epitaxial structure at the active region layers. The coating thicknesses are computed as

$$L_{coat1,2} = c \cdot \frac{\partial \varphi}{2 \partial \omega}. \qquad (2)$$

Here c is the speed of light, $\varphi$ the reflected phase, and $\omega$ is the light angular frequency. One also sees from the above formula that the accuracy with which a laser structure can be fabricated to emit at a specified emission wavelength is directly proportional to the accuracy with which the fabrication process can produce the corresponding cavity length $L_{tot}$. The high precision of the dry etching process therefore allows a specified emission wavelength to be fabricated to a correspondingly high precision.
- The gain bandwidth $g_{BW}$ for mid-IR QCLs is between 100 - 200 cm$^{-1}$ and cannot be engineered, besides its peak

wavenumber $v_0$ which is determined by the active region design and fixed by the growth accuracy. The gain curve g(v) is described with a Lorentzian lineshape

$$g(v) \propto \frac{\gamma}{(v - v_0)^2 + \gamma^2}, \tag{3}$$

where $\gamma$ is the linewidth and *FWHM* = 2y. The FWHM is about 10% of the lasing wavenumber [6].

• The optical cavity length $L_{tot}$ (see eq. (1)) determines the emission wavenumber v, axial mode index q and consequently the mode-spacing between adjacent Fabry-Perot modes, i.e. the free-spectral range (FSR).

• The FSR in wavenumbers writes as

$$v_{FSR} = \frac{1}{2n_g L_{tot}}, \tag{4}$$

where $n_g$ is the group refractive index.

• The FSR can be translated into a gain margin ratio (in %)

$$\rho = 100 \cdot \left(1 - \frac{g(v_0 + v_{FSR})}{g(v_0)}\right). \tag{5}$$

The gain margin ratio can be used to determine how short the laser cavity needs to be to achieve single mode operation. $\rho$ sets the upper limit for optical cavity length $L_{tot}^{max}$.

• Mirror loss $\alpha_m$ with reflectivities $R_{1,2}$ is given by

$$\alpha_m = \frac{1}{2L_{tot}} \ln(R_1 \cdot R_2). \tag{6}$$

For short cavities the mirror losses are the main contribution that determines the laser threshold. The quality of the mirrors determines how short the laser cavities can be made. In other words $R_{1,2}$ sets the lower limit for the optical cavity length $L_{tot}^{min}$.

• The control of the optical cavity length influences the accuracy of the emission wavenumber. Assuming a nominal cavity length L is required but a shorter cavity is fabricated with length $L' = L - \delta$. Then the emission is shifted by

$$\Delta \tilde{v}_q = v_q(L - \delta) - v_q(L) = v_q \cdot \frac{\delta}{L - \delta} = v_q \cdot \frac{\delta}{L'}, \tag{7}$$

where $v_q$ is the nominal emission wavenumber and q the axial mode index. The rate of the PECVD deposition is of the order of 20 nm/min which translates to an expected cavity length uncertainty of $\pm 10$ nm. Note that for shorter cavities or shorter wavelengths the emission shift increases.

**Parameter space example**

The parameter space is illustrated in the following assuming

• $R_{1,2}$ = 97%

- *FWHM* = 160 $cm^{-1}$

- v = 2222 $cm^{-1}$ ($\lambda$ = 4.5 $\mu m$)

- Cavity length deviation $\delta$ = 10 $nm$.

**Table 1: Parameters as a function of cavity length.**

| Cavity length $L_{tot}$ ($\mu$m) | FSR (cm$^{-1}$) | Gain margin ratio $\rho$ (%) | Mirror loss $\alpha_m$ (cm$^{-1}$) | Wavenumber shift (cm$^{-1}$) |
|---|---|---|---|---|
| 25 | 62.1 | 37.6 | 12.2 | 1.8 |
| 50 | 31.1 | 13.1 | 6.1 | 0.89 |
| 75 | 20.7 | 6.3 | 4.1 | 0.59 |
| 100 | 15.5 | 3.6 | 3.0 | 0.44 |
| 150 | 10.4 | 1.6 | 2.0 | 0.3 |

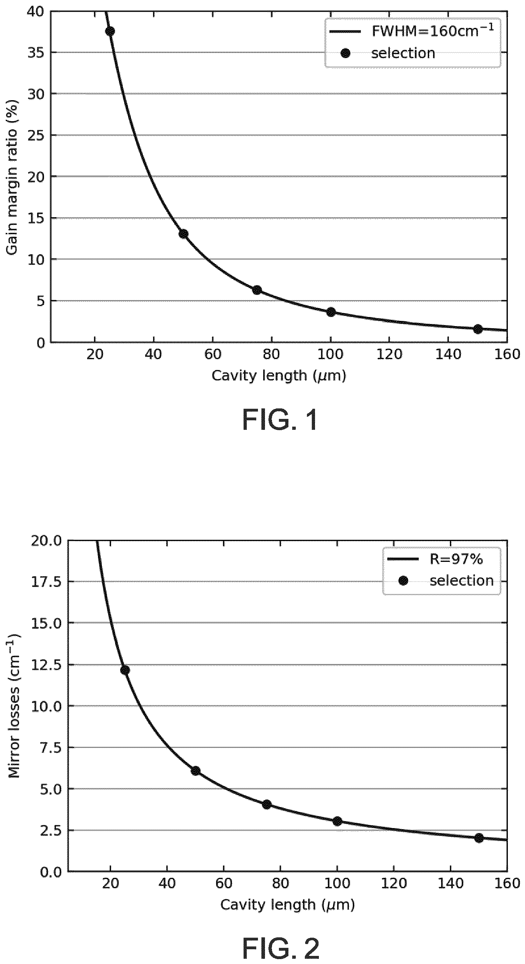

Table 1 shows how the wavenumber shift is expected to have minor influence and the most important factor for successful room temperature single mode operation is to have low mirror losses, i.e. to have high reflectivity mirrors (see Figure 2).

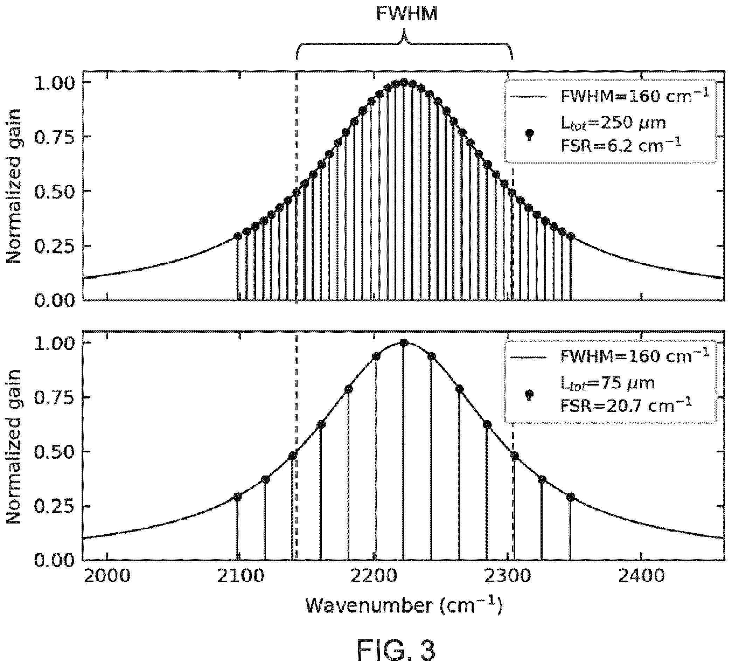

Figure 3 illustrates the resonator modes for a gain curve with *FWHM* = 160 $cm^{-1}$ and cavity lengths of 250 $\mu$m and 75 $\mu$m. It is assumed that the modes are centered around the peak of the gain profile. The modes of longer cavities have a smalller $v_{FSR}$ and therefore multiple modes around peak gain experience practically the same gain, resulting in a small gain margin ratio $\rho$. For shorter cavities $v_{FSR}$ can be large enough such that the gain of the adjacent modes is not the same and only the one closer to the maximum experiences enough gain to lase. Hence, the gain margin ratio $\rho$ is larger. The cavity length is selected to be sufficiently short in relation to the gain bandwidth to cause all longitudinal modes supported by the waveguide, other than the lasing longitudinal mode, to have energies that are far enough away from the lasing wavelength that they have insufficient gain to achieve lasing threshold. Given these considerations and taking account of the gain bandwidth and gain profile of a typical semiconductor structure as used for cascade lasers, the cavity length range that will be of interest is $L_{tot}$ < 100 $\mu m$.

Figure 1 shows the maximum gain margin ratio $\rho$ as a function of cavity length. It can be seen that gain margin ratio $\rho$ increases rapidly for cavity lengths smaller than 100 $\mu$m.

Table 2 lists steps of an example design method for computing what cavity length is needed to produce a laser with a specific emission wavelength, e.g. an emission wavelength matched to a specific target absorption line of a gas to be sensed. The definition of cavity length takes account of both the dry etching and the subsequent facet coating. Optionally, after the dry etching and before the coating, the cavity length could be measured, e.g. with an inline electroluminescence measurement with a longer control cavity. Such a measurement would yield knowledge of $n_g$, $v_{FSR}$, FWHM, $v_0$ before the coating is performed.

**Table 2: Linear cavity design flow with example computation.**

| Step | | Example with $n_g$ = 3.22, *FWHM* = 160 $cm^{-1}$ |
|---|---|---|
| | 1. Target absorption line | $v_T$ = 2222 $cm^{-1}$ |
| | 2. Active region design with accurate growth such that gain peak wavenumber $v_0$ is close to $v_T$. | • For simplicity $v_0$ = $v_T$ |
| | 3. Determine axial mode integer q by choosing an initial optical cavity | • $L_{ini}$ = 50 $\mu m \rightarrow q = 2n_g L_{ini} v_T$ = 72 |
| | length $L_{ini}$ and rounding to the closest integer number. $L_{ini}$ has to be sufficiently small such that the laser is operating in single mode. | |
| | 4. Determine the final optical cavity length according to fabrication limits (i.e. +/- 10 nm). | • $L_{tot} = \dfrac{q}{2n_g v_T} = 50.3156\ \mu m$<br>• $L_{tot,fab}$ = 50.32 $\mu m$ |

(continued)

| Step | Example with $n_g$ = 3.22, *FWHM* = 160 $cm^{-1}$ |
| --- | --- |
| 5. Compute the emission wavenumber and the deviation with respect to target absorption line. | • $v \approx 2221.805\ cm^{-1}$<br><br>• $\delta_T = 1 - \dfrac{v}{v_T} \approx 9 \cdot 10^{-5}$ |

LASER OPERATION

QCLs and ICLs embodying the invention will typically be operated at output powers in the range of 0.5 to 5 mW, e.g. at 1 mW. Electrical power consumption in the lasing regime is typically below 100 mW. By way of example, a solid-state lithium-ion smartphone battery based on today's technology has a capacity of about 4000 Watt hours which would allow a 100 mW electrical power consumption device to run continuously for 40'000 hours, i.e. 4 ½ years. QCLs and ICLs embodying the invention may be driven to emit continuous wave (CW) or pulsed. Pulsed operation is useful for certain kinds of spectroscopy. QCLs and ICLs embodying the invention can operate single mode at room temperature over a significant range of drive currents above threshold. Typical emission wavelengths for a QCL or ICL embodying the invention is in the range 2 to 20 micrometers.

SEMICONDUCTOR DESIGN

QCLs and ICLs embodying the invention will be manufactured from a semiconductor wafer with a suitable epitaxial layer structure. The semiconductor layers that achieve the waveguiding and lasing action will comprise: a lower cladding layer; a plurality of active region layers; and an upper cladding layer as is well known in the art. Moreover, the waveguide for the laser cavity will be formed by some suitable known design, such as a ridge or buried heterostructure. To restrict the cascade laser to single mode operation as desired it is also necessary that the waveguide has a width that is sufficiently narrow so that the waveguide only supports one *transverse* mode. Elsewhere in this document, we are of course referring to the *axial* (syn: *longitudinal*) mode(s) defined by the cavity length.

The semiconductor layers will be grown epitaxially in sequence on a suitable substrate, the substrate thus supporting the semiconductor layers. However, in some instances it may be beneficial to remove the substrate after growth, for example with a lapping and selective etching process, so the original substrate at the time of growth may not be present in the final device.

It is noted that the lower cladding layer can be an integral part of the substrate, in which case a structurally distinct lower cladding layer is not present. This may be the case with a doped substrate.

A wafer may be diced to provide individual cascade lasers. Alternatively, the surface-emitting design lends itself to making one- or two-dimensional arrays of lasers. A two-dimensional array could have a simple rectangular or square grid or some other form of packing. In other embodiments, the array may be a 1D array, e.g. arranged in a line. A laser array may therefore be provided that comprises a plurality of cascade lasers as described above that are formed monolithically as a single chip. This may also be useful for providing a laser array, where each laser has a different emission wavelength and is optionally individually drivable so that any laser in the array can be selected. The different emission wavelengths of such a laser array may be matched to different atomic or molecular transitions for sensing different gases or different signature absorption bands of the same gas. Typical applications may be gas sensing of ambient gases (e.g. CO, $CO_2$) or sensing gas residues from explosive compounds or narcotics compounds. The close packing of lasers with different emission wavelengths may also be useful for active infrared imaging or lidar (Light Detection and Ranging) applications.

To form a quantum cascade laser, the plurality of active region layers form a superlattice structure configured to provide gain through intraband transitions between quantum well subbands. The in-plane waveguiding action can be provided by refractive index contrast in the vertical direction between lower refractive index, lower and upper cladding layers, and a higher refractive index, active region. In-plane waveguiding confinement for the lasing mode(s) is therefore provided with sufficient overlap in the vertical direction with the gain medium of the active region.

Suitable semiconductor materials systems for fabrication are GaAlInAs (sometimes referred to as arsenide-based), GaAlInAsP (sometimes referred to as phosphide-based), and GaAlInAsSb (sometimes referred to as antimonide-based). Suitable metallic materials for the electrodes and the end reflectors include Ge and the metals Au, Ti, Ni and Pt.

The upper and lower cladding layers are typically n-type doped. The active region layer sequence may be grown in either an np or pn sequence. Consequently, in different embodiments the biasing for current injection across the contacts may be in either sense. Most commonly for a QCL and ICL the upper and lower claddings are both n-type and the top contact is the negative contact.

The active region for forming the QCL or ICL can follow any known design. For this reason, the precise layer sequence of the active region has not been described in detail. For QCLs, the most common designs are bound-to-bound, bound-to-continuum and continuum-to-continuum.

To form an interband cascade laser, the plurality of active region layers form a superlattice structure configured to provide gain through interband transitions between quantum well subbands. The in-plane waveguiding action can be provided, for example, by refractive index contrast in the vertical direction between lower refractive index, lower and upper cladding layers and higher refractive index, lower and upper separate confinement layers and active region. In other words, the lower separate confinement layers are arranged between the active region and the lower cladding layer, and the upper separate confinement layers are arranged between the active region and the upper cladding layer. In-plane waveguiding confinement for the lasing mode(s) is therefore provided with sufficient overlap in the vertical direction with the gain medium of the active region.

DESCRIPTION OF FIGURES

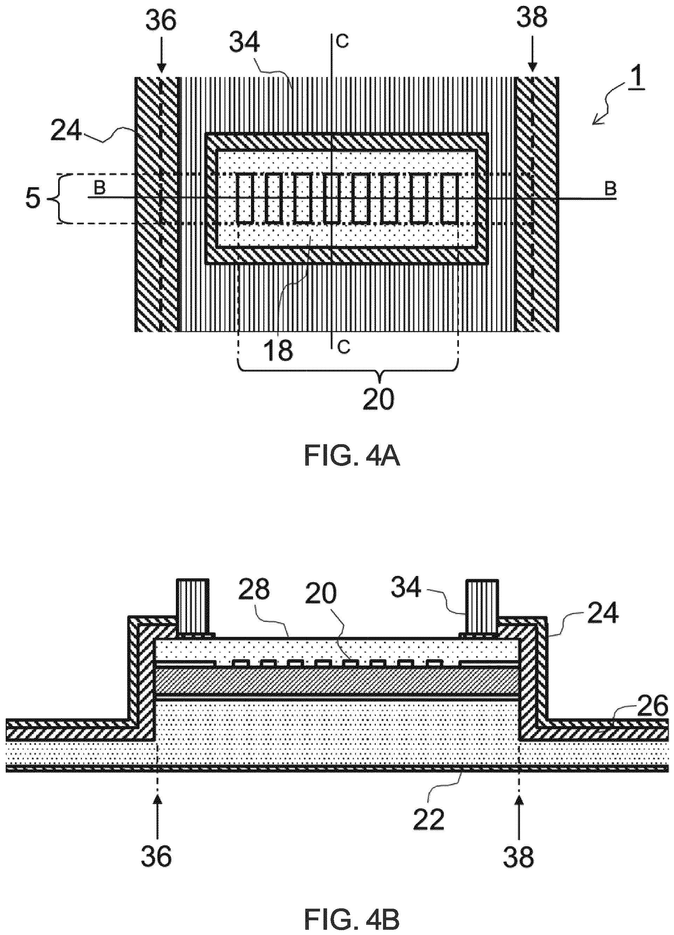

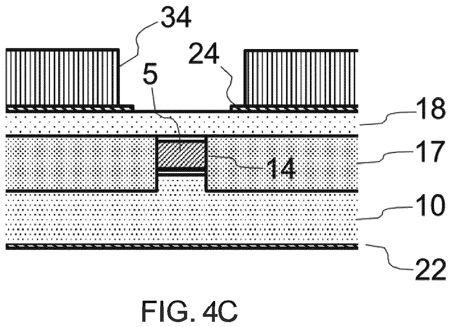

Figures 4A to 4C are three orthogonal schematic views of a QCL chip 1 according to an embodiment of the invention; Figure 4A is a plan view; Figures 4B and 4C are parallel and perpendicular sections along the lines B and C shown in Figure 4A. A semiconductor waveguide 5 of the buried-heterostructure type is bounded by end mirrors to form a Fabry-Perot cavity. The chip structure comprises a bottom electrode 22, a substrate 10, active layers 14 (e.g. a MQW structure of a suitable materials combination), an upper cladding layer 18 and a top electrode 24. A linear second order grating 20 is buried in the structure above the active layers 14. The buried-heterostructure waveguide 5 is terminated at either end by a first yz-plane mesa side surface 36 and a second yz-plane mesa side surface 38. After etching away through the active layers 14 to form the buried-heterostructure waveguide 5, a semiconductor insulating layer 17 is regrown (see Figure 4C). A dieletric layer 26 is formed on the side surfaces 36, 38. A metal layer 24 forms not only the top contact but is also deposited over the dielectric layer 26 to form end mirrors for the waveguide and so form the cavity. A subsequent electroplated metallization 34 provides an additional heat reservoir. The metal layer 24 of the top contact and also subsequent metallization 34 leave an open aperture for surface emission of the light coupled out by the linear second order grating 20. Referring to Figure 4A, the aperture is rectangular in this example.

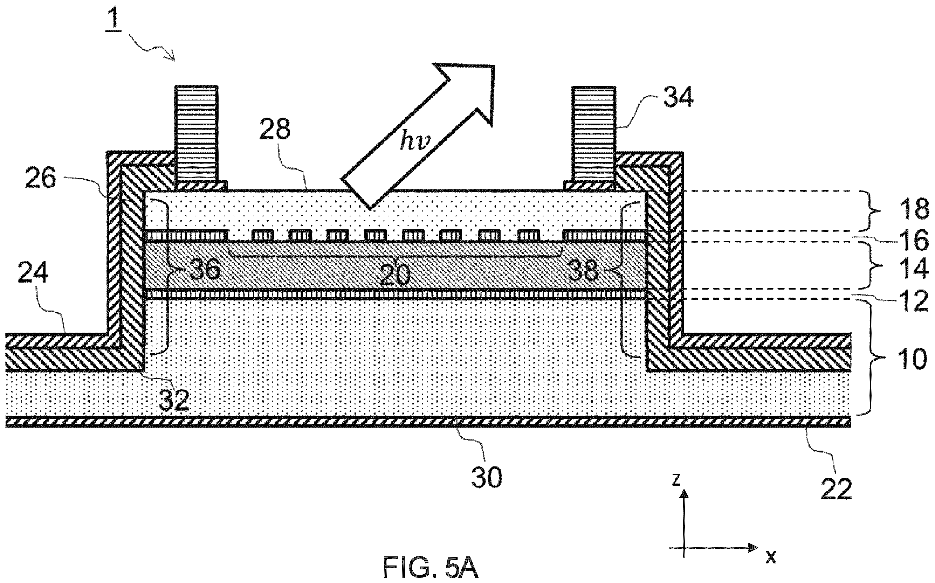

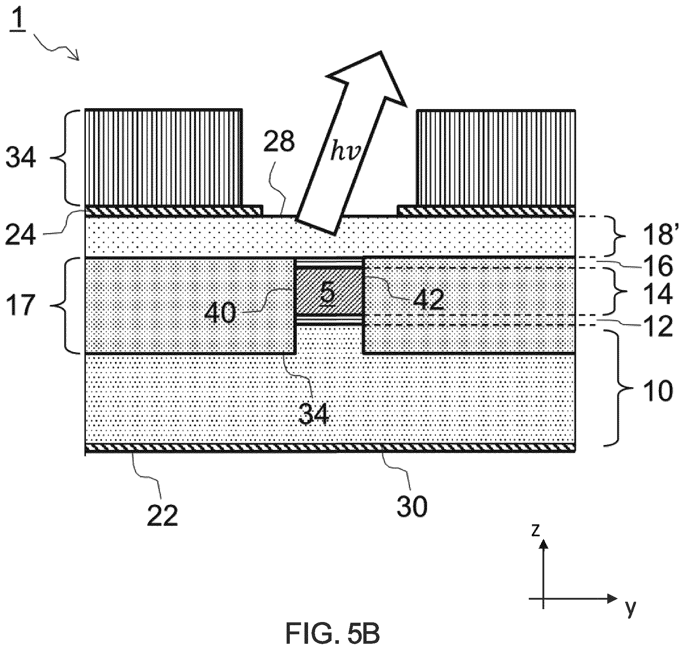

Figures 5A and 5B are more detail schematic of the same sections as shown in Figures 4B and 4C respectively. The semiconductor heterostructure is now described from the substrate upwards, i.e. in growth sequence of the layers. In a Cartesian coordinate system, the growth direction is the z-direction and the plane of the layers is an xy-plane. A doped substrate 10 is provided, e.g. from doped InP. A lower cladding layer 12 is deposited on the substrate 10, e.g. of doped InGaAs. An additional buffer layer, e.g. of doped InP, may be deposited on the substrate 10 before the lower cladding layer 12. The layers for the active region 14 are then deposited including a sequence of layers formed by alternating deposition of different bandgap materials to form a superlattice structure, e.g. two materials selected from the materials system InGaAlAsP to be lattice matched to InP - most commonly InGaAs/AlInAs. Since the active region layer design options are known in the art, the individual active region layers are not shown to avoid overcomplicating the drawing. After completion of the growth of the active region layers 14, a layer 16 of semiconductor material is deposited. The layer 16 is then selectively removed by patterning and etching in a central area to leave the structured partial layer 16 for forming the grating as illustrated. The partial layer 16 is then overgrown by the upper cladding layer 18 to form the second order grating 20. What is important for the formation of the second order grating 20 is a refractive index difference between the semiconductor material of the grating layer 16 and the semiconductor material of the overgrown upper cladding layer 18, so the semiconductor material of the layer 16 could have either lower or higher refractive index than that of the upper cladding layer 18. The upper cladding layer 18 may be of InP or InGaAs, for example, and terminates at a top surface 28. The bottom of the semiconductor heterostructure is formed by the bottom surface 30 of the substrate 10. An in-plane waveguiding region is thus formed by refractive index contrast in the vertical direction between lower refractive index, lower and upper cladding layers 10 and 18, and a higher refractive index, active region layer sequence 14.

After growth of the semiconductor heterostructure, the chip is subjected to lithographic processing to form the necessary contacts for biasing across the active region to provide carrier injection and to form the low loss end mirror surfaces 24, 26 for the laser's linear cavity.

The chip for each QCL is initially defined by etching trenches into the top surface 28 of the wafer to form an array of mesas, one for each QCL, in a rectangular or square grid. Dry etching may be used, for example. The etching to form the mesas extends through the upper cladding layers 18, 16, the active region 14, the lower cladding layer 12 and part way through the substrate 10, the exposed surface of the substrate being labelled with reference numeral 32. The side surfaces of the waveguide-forming mesa are first and second surfaces 36 and 38 in the yz-plane (see Figure 5A) and, in the xz-plane, first and second side surfaces 40, 42 (see Figure 5B). As stated above in Equation 1, the cavity length and hence the laser emission wavelength is defined by the separation between the first and second yz-plane surfaces 36 and 38 and the thicknesses of the first and second end mirrors as defined by the dielectric and metal layers 26, 24. Moreover, as is conventional, all four surfaces 36, 38 and 40, 42 collectively serve to guide carrier injection into the active region. A dielectric layer 26, for example silicon nitride ($Si_3N_4$), is then deposited at least on the mesa surfaces 36, 38 but more conveniently may extend further to fully or partially cover other mesa surfaces such as 28, 32. A metallization layer 24 is then deposited. The metallization layer 24 has two functions. A first function is to provide an Ohmic top contact for driving the laser. A second function is to form part of the low loss end mirrors for the laser cavity in combination with the dielectric layer 26. The top contact function is fulfilled as illustrated by a portion of the metallization layer 24 coming into ohmic contact with the upper cladding layer 18, i.e. without the dielectric layer 26 being interposed. The end mirror function is fulfilled as illustrated by a double layer of dielectric and metallization 24, 26 being formed at the two ends of the in-plane linear waveguide on the zy-plane mesa surfaces 36, 38. Emission as induced by the second order grating 20 is in an upward direction through the top surface 28 as indicated schematically by the arrow labelled *hv*.

Example materials would be: substrate 10 (n:InP), lower cladding layer 12 (n:InGaAs), active layers 14 (MQW structure InGaAs/AlInAs), upper cladding layer 16 (n:InGaAs), upper cladding layer 18 (n:InP), base contact layer 22 (metallization; Au), top contact & end mirror layer 24 (metallization; Au), dielectric layer 26 ($Si_3N_4$), top contact electroplated 34 (metallization; Au).

It will be understood that although the cladding layers 10, 12, 16 and 18 are illustrated and described as single layers, they may be formed by multiple layers. Moreover, the substrate 10 may serve as the lower cladding layer 14, in which case a separate lower cladding layer would be omitted. In the above, we use the example of a second order grating for outcoupling. It will be understood that higher order gratings could be used, e.g. third, fourth or still higher order gratings.

After defining the second order grating 20, the waveguide core is defined by means of wet- or dry-etching methods. To selectively electrically pump the waveguide core, where the optical gain occurs, an insulating layer 17 (e.g. p:InP) is regrown. Subsequent regrowth of a contact cladding layer 18' completes the waveguide definition, since the layers 10, 18, 18', 17 (e.g. all InP) have a lower refractive index than the waveguide core cladding layers 12, 16 (e.g. InGaAs) and the active layers 14. On the top surface 28, the metallic layers 24 and 34 are deposited to ensure electrical injection into the active layers and to provide a heat reservoir.

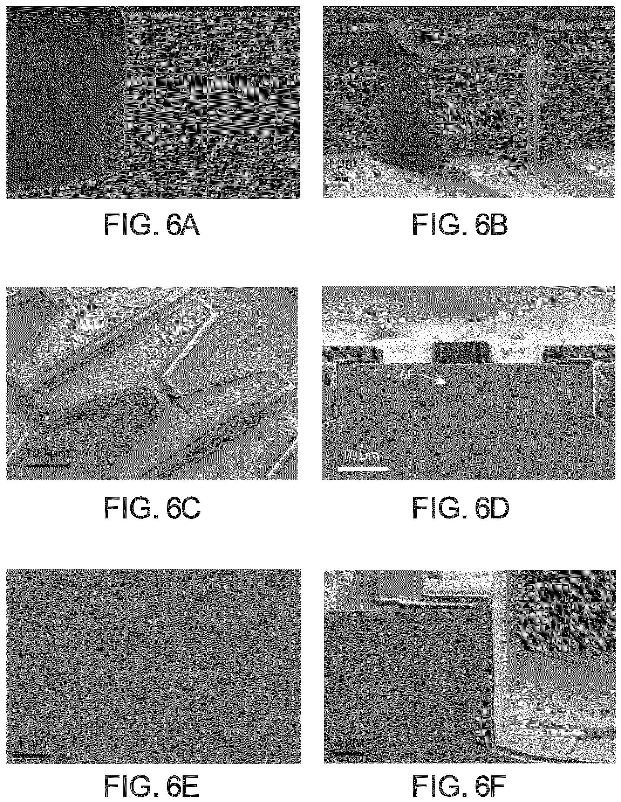

Figures 6A to 6F are SEM images of example structures. Figure 6A shows a cleaved mesa in the parallel direction, the first yz-plane mesa side surface is shown (36 in Figure 5A). The mesa was dry-etched prior to cleaving. The dry-etched yz-plane mesa side surface is smooth and the profile is nearly vertical. The active region and the upper and lower InGaAs cladding layers are visible (12, 14, 16 in Figure 5A). Figure 6B shows the front view of the first yz-plane mesa side surface (36 in Figure 5A). The buried heterostructure QCL facet is visible and the dry-etching recipe was the same as used for the structure in Figure 6A. Figure 6C shows an angled plan view of quantum cascade surface emitting lasers before electroplating. The cavity is 50 μm long and the aperture for surface emission from the linear second order grating (rectangular aperture in Figure 4A) is indicated with the black arrow. The end mirror deposited on the first yz-plane mesa side surface (36 in Figure 5A) is visible. Between the mesas the bottom surface (32 in Figure 5A) can be seen. Figure 6D shows a cleaved device structure in the parallel direction (corresponding to the section of Figure 5A) after electroplating. Both end mirrors, the active region, and the upper and lower InGaAs cladding layers are visible. The arrow in Figure 6D indicates the second order grating (20 in Figure 5A). Figure 6E shows a close-up view of the second order grating of Figure 6D. Figure 6F shows the end mirror on the second yz-plane mesa side surface (38 in Figure 5A).

We now consider the specific case of a dielectric-metal end mirror design.

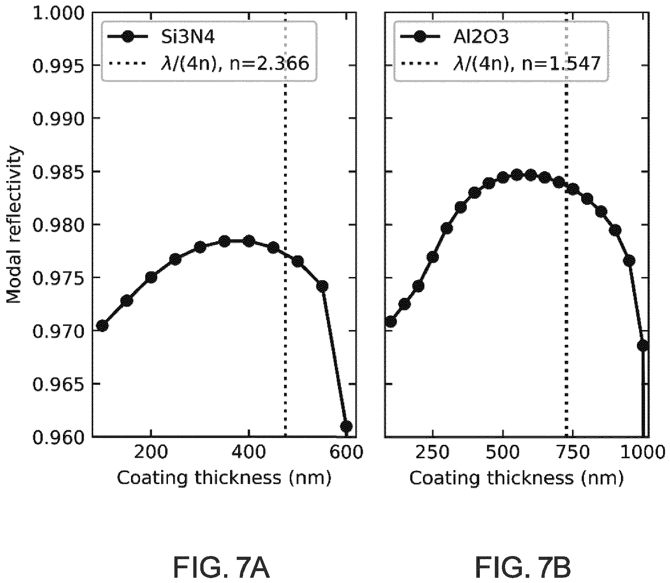

Figures 7A and 7B are graphs plotting modelling results that calculate the relationship between reflectivity and dielectric layer thickness of an example end mirror design of the type in which the end mirror is formed by a dielectric layer followed by a metal layer. In Figure 7A, the dielectric material is $Si_3N_4$. In Figure 7B, the dielectric material is $Al_2O_3$. The lasing wavelength is $\lambda$ = 4.5 μm. The metal used for the modelling is gold. The metal layer is continuous, i.e. there is no aperture of the kind disclosed in Wang et al [9]. The refractive index of $Si_3N_4$ at 4.5 μm is taken as *n* = 2.366, which means that $\lambda/4$ = 475 nm as shown in Figure 7A by the vertical dotted line. The refractive index of $Al_2O_3$ at 4.5 μm is taken as *n* = 1.547, which means that $\lambda/4$ = 727 nm as shown in Figure 7B by the vertical dotted line. With both example dielectric materials high reflectivities R ≥ 97% are obtained over a relatively wide range of thicknesses above and below $\lambda/4$. However, maximum reflectivity is not very close to $\lambda/4$ but rather occurs at smaller thicknesses of around 0.75·$\lambda/4$. Referring to the graphs, as dielectric layer thickness increases from $\lambda/4$, there is at first a gradual drop off in reflectivity but then a much more rapid decrease above about 1.2·$\lambda/4$ which may be caused by the thicker dielectric layer allowing the beam to diverge more and, at some divergence, it may be possible for some power to start propagating in the plane of the dielectric layer and be lost to reflection. Referring again to the graphs, as dielectric layer thickness decreases from $\lambda/4$, there is quite a gradual drop off in reflectivity over a relatively large range of thicknesses, with reflectivity dropping below 97% only at quite small thicknesses of 0.2·$\lambda/4$ for the $Si_3N_4$/Au example and 0.14·$\lambda/4$ for the $Al_2O_3$/Au example. The range of reflectivities with R ≥ 97% is between about 0.2 - 1.2·$\lambda/4$ for the $Si_3N_4$/Au example and about 0.14 - 1.3·$\lambda/4$ for the $Al_2O_3$/Au example.

For a dielectric-metal end mirror we now discuss how the parameter 'Lcoat' is determined. For the dielectric layer, its physical thickness equates to its effective thickness, i.e. the thickness relevant for the layer's optical reflection properties. On the other hand, for the metal layer, the effective thickness relates to the depth within the metal layer where the electromagnetic field of the light is still significant. We take the effective thickness of the metal layer to be the skin depth, $\delta$, of the light that is to be reflected, where skin depth is defined as the electromagnetic field strength where the amplitude of the electromagnetic field falls by 1/e, i.e.

$$\delta = \lambda/(2 \cdot \pi \cdot \kappa)$$

where $\kappa$ is the imaginary part of the refractive index. For usual coating metals, the penetration depth is expected to be smaller than 30 nm across the mid-infrared spectrum of 2-20 $\mu$m. For gold, the skin depth varies smoothly from about 23 nm at 2 $\mu$m to 27 nm at 20 $\mu$m as is known, for example, from Olmon, Slovick *et al* [19]. The physical thickness of the metal layer will typically be made several multiples greater than the skin depth, e.g. a few hundreds of nanometres, so the effective thickness of the metal layer will have a constant value equal to the skin depth at the lasing wavelength. As a consequence, providing that the metal layer is much thicker than the skin depth of light in the metal at the lasing wavelength, the physical thickness of the metal layer will not affect the modal reflectivity.

In summary, in the case of a dielectric-metal mirror, the parameter 'Lcoat', i.e. the effective thickness of the mirror that contributes to the cavity length, will be the sum of the contributions from the dielectric layer and the metal layer. The contribution from the dielectric layer is the physical thickness of the dielectric layer multiplied by the refractive index of the dielectric. The contribution from the metal layer is the skin depth at the lasing wavelength for the metal.

We now consider the specific case of a dielectric-dielectric end mirror design. In this case, the end mirror is formed from alternating layers of two different dielectric materials with differing refractive index values.

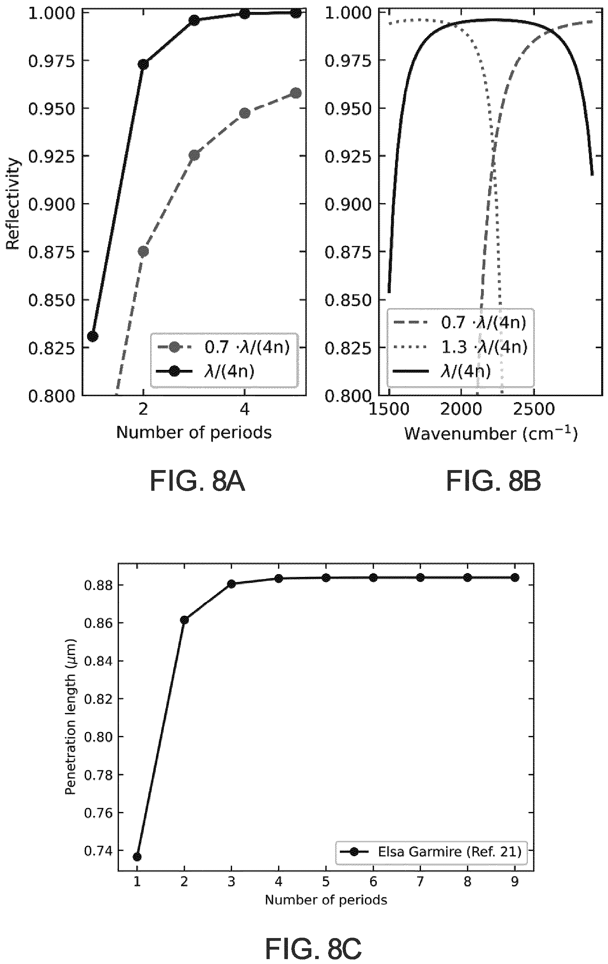

Figures 8A, 8B and 8C show modelling results for an example materials combination of $Al_2O_3$/Ge. (Another option would be to use Si in place of Ge.) The lasing wavelength, $\lambda$, is 4.5 $\mu$m.

In the dielectric-dielectric case, to obtain the high reflectivity that is necessary to achieve lasing in such a short cavity, it is beneficial to provide more than one pair of layers, i.e. multiple repeats of the two dielectric material layers are beneficial. Moreover, the individual layers will have the thicknesses needed to form a Bragg reflector at the lasing wavelength. Classically, the layer thicknesses of the two dielectric materials to form a Bragg grating are both $\lambda/4$, where the physical thickness of the layers of the two dielectric materials will differ as a result of their different refractive indices. This is referred to as the Bragg condition.

Figure 8A models reflectivity R as a function of the number of dielectric-dielectic layer repeats or periods when the layer thickness in both dielectric materials is $\lambda/4$ (black line). Namely, the layer thickness for each $Al_2O_3$ layer is 727 nm ($\lambda/4$ at 4.5 $\mu$m) and the layer thickness for each Ge layer is 280 nm ($\lambda/4$ at 4.5 $\mu$m). The graph shows how, with each additional repeat of a pair of dielectric layers, more power is reflected until the total reflectivity saturates. Two repeats already achieves around 96% reflectivity and three repeats is sufficient to obtain close-to-maximum reflectivity of around 98%. The number of repeats of each pair of layers required to attain saturation, i.e. to attain close to maximum reflectivity, will generally be a small integer value, e.g. 3 or 4 pairs. The grey dashed line shows the reflectvity as a function of the number of dielectric-dielectric repeats or periods when the layer thickness in both dielectric materials is $0.7 \cdot \lambda/4$. This line overlays with the case of $1.3 \cdot \lambda/4$ which is not shown in the graph. It can be seen that after 3 periods the reflectivity is still above 90%.

Figure 8B shows, for the example of a mirror with three $Al_2O_3$/Ge repeats as modelled in Figure 8A, the effect on reflectivity when the lasing wavelength deviates from the design value of $\lambda = 4.5 \mu$m, i.e. as the situation moves away from the Bragg condition (black line). The reflectivity drop off from maximum is symmetric (in wavenumbers) and is quite gradual and small in magnitude over a relatively large range of wavelengths. For example, the range of reflectivities with $R \geq 95\%$ is between about 1700 - 2800 cm$^{-1}$, i.e. 3.6 - 5.9 $\mu$m, or 0.8 - 1.3 times the Bragg condition. The reflectivities as function of wavenumber are shown in the cases where the layer thicknesses in both dielectric materials are $0.7 \cdot \lambda/4$ and $1.3 \cdot \lambda/4$ (grey dashed and grey dotted line respectively). It can be seen that at the target wavelength A = 4.5 $\mu$m (2222 cm$^{-1}$) the reflectivity is above 90 % despite the significant deviation from the Bragg condition. In other words, close compliance with the Bragg condition does not appear to be necessary in order to still maintain a reflectivity for the Bragg mirror that is close to the maximum attainable when the Bragg condition is exactly met.

In the case of a dielectric-dielectric mirror, the parameter 'Lcoat', i.e. the effective thickness of the mirror that contributes to the cavity length, is taken as the effective penetration depth of the electromagnetic field at the lasing wavelength into the Bragg mirror. The effective penetration depth can be determined by computing the complex reflection of the phase $\varphi$ can be extracted from $r \cdot e^{j\varphi}$. The effective penetration depth can then be computed by formula (2) above which, for the example configuration used in Figure 8A and 8B, gives a penetration depth of 881 nm. The penetration depth of 881 nm compares with the physical thicknesses of the two dielectric layers $Al_2O_3$ and Ge which are 727 nm and 280 nm respectively. Analytical results for the penetration length which can be used instead appear in the literature, e.g. Babic and Corzine [20] - see equation 22 therein - and Garmire [21] - see equations 4 and 28 therein. According to the formulae of Garmire, the penetration depth of the example configuration is 883 nm, i.e. almost the same. The effective penetration length will saturate as the number of repeats is incremented (for the same reason that the reflectivity saturates), since only a very small proportion of the mode power penetrates the mirror to a depth beyond the first few dielectric-dielectric interfaces.

Figure 8C is a graph plotting penetration depth as a function of the number of dielectric layer pairs, i.e. the number of periods, as calculated from the complex reflection of the phase. The results are for the example configuration of Figures 8A and 8B. As can be seen, the penetration depth saturates after about 4 periods.

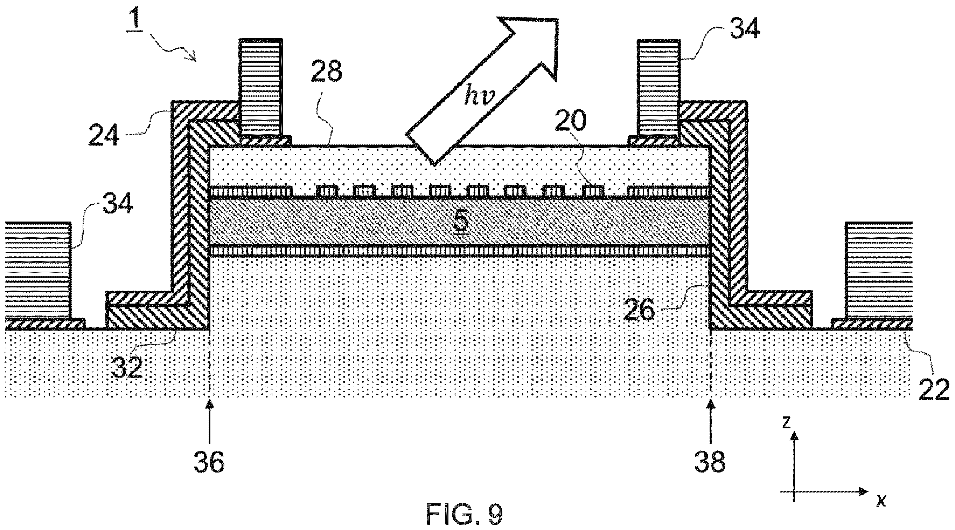

Figure 9 shows a section similar to Figure 5A for an alternative embodiment with a different formation of the lower contact 22. Compared to Figure 5A the lower contact is formed on etched upper surface 32. This allows process and characterize the devices from one side without flipping the wafers. Other features will be recognized by comparison with Figure 5A.

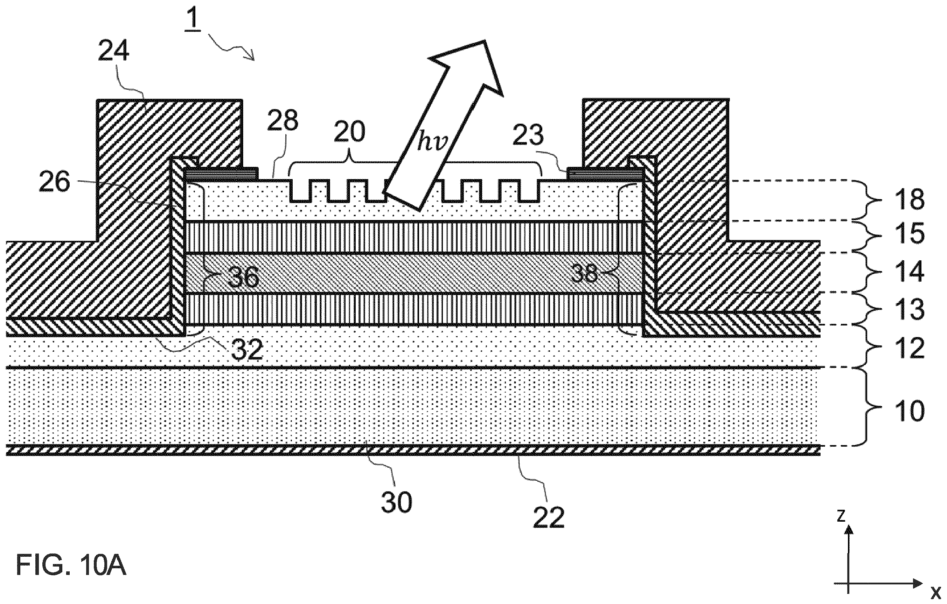

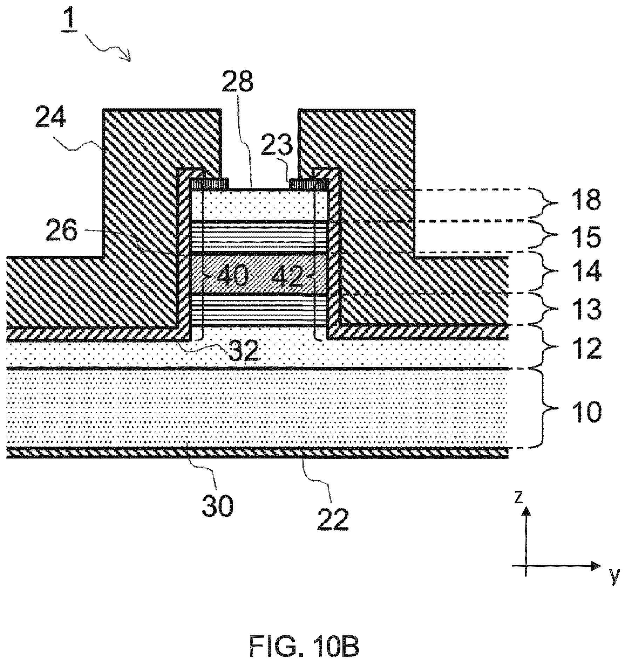

Figures 10A and 10B are schematic parallel and perpendicular cross-sections of an ICL 1 according to an embodiment of the invention which can be compared with the QCL embodiment shown in Figures 5A and 5B.

As in the QCL structure of Figures 5A and 5B, the side surfaces of the waveguide-forming mesa are first and second surfaces 36 and 38 in the yz-plane (see Figure 10A) and, in the xz-plane, first and second side surfaces 40, 42 (see Figure 10B). As stated above in Equation 1, the cavity length and hence the laser emission wavelength is defined by the separation between the first and second yz-plane surfaces 36 and 38 and the thicknesses of the first and second end mirrors as defined by the dielectric and metal layers 26, 24.

One difference to note compared with the QCL of Figures 5A & 5B is that, for a GaSb-based ICL, there is at the moment no suitable regrowth technology available. The second order linear grating 20 is therefore formed differently. One option is as illustrated, which is to etch a grating structure into the top surface 28 of the upper cladding layer 20. An alternative way of forming the grating is to deposit an additional high index material (for example Ge) on top of the upper cladding layer 18 and then to pattern the high index layer to form the grating. Emission as induced by the second order grating 20 is in an upward direction out of the top surface 28 as indicated schematically by the arrow labelled *hv*.

Another difference between an ICL and a QCL is that the waveguiding is produced differently, since in an ICL the active region layers 14 will not generally have a sufficiently high enough refractive index relative to the cladding layers to provide the necessary waveguiding confinement in the vertical direction. In order to provide in-plane waveguiding and hence sufficient overlap between the waveguiding mode(s) and the gain medium provided by the active region 14, lower and upper separate confinement layers (SCLs) 13 and 15 are provided. The SCLs 13 and 15 are made of a material having higher refractive index and are provided below and above the active region layers 14. The substrate 10 may be GaSb, either undoped or n-type. The SCLs 14 and 18 may be formed n-doped GaSb. The lower and upper cladding layers 12, 18 are lightly doped n-type and may be of bulk alloy AlGaAsSb that is lattice matched to GaSb, i.e. the substrate material, or InAs/AlSb superlattices.

The active region layers 14 of an ICL comprise an active quantum well (QW) part, a hole injector part, and an electron injector part. The active QW part may be formed by InAs/GaInSb QWs. The hole injector part may be formed by coupled GaSb/AlSb QWs. The electron injector part may be formed of coupled InAs/AlSb QWs. In an ICL, in view of the narrow bandgap materials, it may also be convenient for the top contact to be partially formed by a degeneratively doped semiconductor layer 23, e.g. n+ doped InAs(Sb). A dielectric layer 26, for example silicon nitride ($Si_3N_4$), is deposited at least on the mesa surfaces 36, 38. A top contact and end mirror metallization layer, e.g. Au, is then deposited over the degeneratively doped semiconductor layer 23 and around the sides of the mesa structure covering also the dielectric layer 26. A base contact metallization layer 22, e.g. Au, is formed on the bottom surface 30 of the substrate 10. The end mirror function is fulfilled as illustrated by the double layer of dielectric and metallization 24, 26 formed at the two ends of the in-plane linear waveguide on the zy-plane mesa surfaces 36, 38.

Another consequence of no regrowth technology being available for a GaSb-based ICL is that after formation of the waveguide-forming mesa, the xz-plane side surfaces 40, 42 are coated with a suitable dielectric layer 26, such as $Si_3N_4$, which may be deposited at the same time as depositing the dielectric layer 26 on the yz-plane side surfaces 36, 38 to form the end cavity mirrors - hence use of the same reference numeral. Alternative materials for the dielectric sidewall coating are $SiO_2$, $Al_2O_3$ and MgO. The dielectric layer 26 on the xz-plane side surfaces 40, 42 also provides passivation to ensure that the desired current flow takes place through the active layer 14 in the z-direction. The side insulating layer 26 also provides lateral optical confinement for the waveguiding modes due to its lower refractive index compared to the mesa layers 12, 13, 14, 15, 18. To remove the heat and to electrically contact the active region (via the degeneratively doped layer 23) a metallization layer 24 is provided.

An example semiconductor layer sequence for an ICL starts from a substrate 10 of Te:GaSb (n-doped). A GaSb buffer layer (not shown) is provided to remove residual oxides and provide a flat surface. The lower cladding layer 12 comprises a highly n-doped InAs/AlSb superlattice having a short period (~ 5nm). A lower SCL 14 of GaSb (lightly n-doped) is then deposited. There then follows the active region layers 16 of W-type MQWs InAs/GaInSb/AlSb, where a hole injector is formed by GaSb/AlSb layers and an electron injector by InAs/AlSb layers. The upper SCL 18 is of n-doped GaSb. The upper cladding layer 20 is of an n-doped InAs/AlSb superlattice. A cap layer for the top contact is made of highly n-doped InAs to form a low resisistance Ohmic top contact.

As for the QCL as shown in Figure 9, one variant for the ICL is for the lower contact 24 to be deposited instead onto the etched upper surface 32.

In summary of the above, we have described a method of manufacturing a single-mode cascade laser 1 that will lase at a specified lasing wavelength, as well as a cascade laser 1 manufactured according to this method. The cascace laser is based on a waveguide 5 that is terminated with a precisely specified length by etching its end facets 36, 38. The waveguide length is typically less than 100 micrometers. An cavity end mirror is formed on each end facet by depositing a layer of one optical material 24 and another optical material 26, the two optical materials having differing refractive indices. Each end mirror layer has a thickness lying within a range extending above and below one-quarter of the intended lasing wavelength within the optical material from which the mirror layer is formed. The precise definition of the length of the waveguide and of the thicknesses of the end mirror layers together with the sub-100 micrometer waveguide length provide a Fabry-Perot cavity that supports lasing of only one longitudinal mode of the waveguide at the specified lasing wavelength.

GAS SENSOR APPLICATIONS

An important area of application for QCLs and ICLs embodying the invention is for gas sensing, namely as a component of an absorption-based gas sensor of the type based on absorption of light by a gas molecule. Gas sensors are used in multiple industrial and scientific applications [11]. The mid-infrared part of the electromagnetic spectrum, in particular between 2.5 to 15 $\mu$m, is of interest, since it encompasses the fundamental roto-vibrational absorption lines of many light gas molecules found in the atmosphere, including numerous greenhouse gases and pollutants [10]. The absorption strength of these fundamental transitions is orders of magnitude larger compared with the higher order transitions that exist at shorter wavelengths accessible by conventional (i.e. non-cascade) laser diodes. Some example molecules and the wavelengths of their fundamental absorption lines are listed in Table 1.

**Table 3: Absorption frequencies of selected molecules in the mid-infrared.**

| Greenhouse or pollutant gas | Wavenumber [cm$^{-1}$] |
|---|---|
| Carbon monoxide (CO) | 2050 - 2300 |
| Carbon dioxide ($CO_2$) | 2350 - 2450 |
| Ozone ($O_3$) | 1000 - 1150 |
| Nitric monoxide (NO) | 1850 - 1950 |
| Nitric dioxide ($NO_2$) | 1550 - 1650 |
| Nitrous oxide ($N_2O$) | 1580 - 1630 |
| Ammonia ($NH_3$) | 1500 - 1800 |
| Methane ($CH_4$) | 1250 - 1400 |

Molecules released from solid-state substances such as narcotics or explosives could also be potentially detected, provided there are strong absorption lines in the mid-infrared.

Gas sensors of this kind measure light absorption caused by a change in the vibrational and/or rotational state of a gas molecule. The light absorbing transition is referred to as a ro-vibrational transition. One example is the 4.26 $\mu$m band of carbon dioxide ($CO_2$) that is generated by an asymmetric stretch. The 4.26 $\mu$m $CO_2$ band is of particular interest, since it does not coincide with strong absorption by any other common atmospheric gas.

Suitable infrared detectors include photodiodes, pyroelectric, thermopile or photoacoustic detectors [11]. Example types of such sensor are the non-dispersive infrared sensor (NDIR) and the photoacoustic sensor.

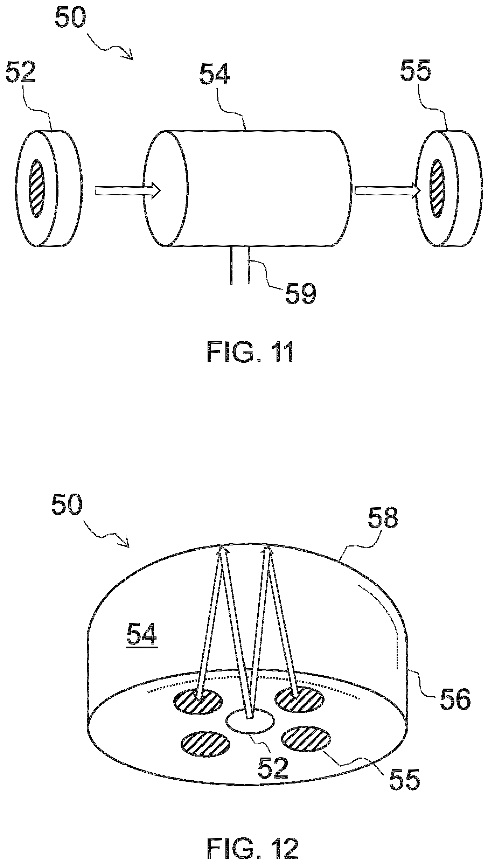

Figure 11 is a schematic perspective drawing of an example gas sensor 50 incorporating a QCL or ICL 52 according to an embodiment of the invention as the emitter. The gas sensor 50 is in a linear transmission configuration in which the emitter 52 outputs a laser beam that traverses a gas cell 54 of cylindrical shape that contains a gas to be sensed and is then incident on an infrared detector 55. Gas to be sensed may be introduced into and removed from the gas cell 54 via a port 59.

Figure 12 is a schematic perspective drawing of an example gas sensor 50 incorporating a QCL (or ICL) 52 according to an embodiment of the invention as the emitter. The gas sensor 50 is in a planar reflection configuration in which the gas to be sensed is contained in a gas cell 54 formed from a planar base 56 in combination with a reflective dome 58 which has an ellipsoid shape. The planar base 56 has mounted therein the emitter 52 and also a plurality of infrared detectors 55. The emitter 52 outputs a divergent laser beam upwards into the gas cell 54, the laser beam then being reflected from the underside of the dome 58 whereupon it traverses the gas cell 54 again in a downwards direction and is incident on the infrared detectors 55.

In a LIDAR gas sensor, it will be appreciated that a gas cell is not present. Rather a small proportion of the emitted light is backscattered and detected.

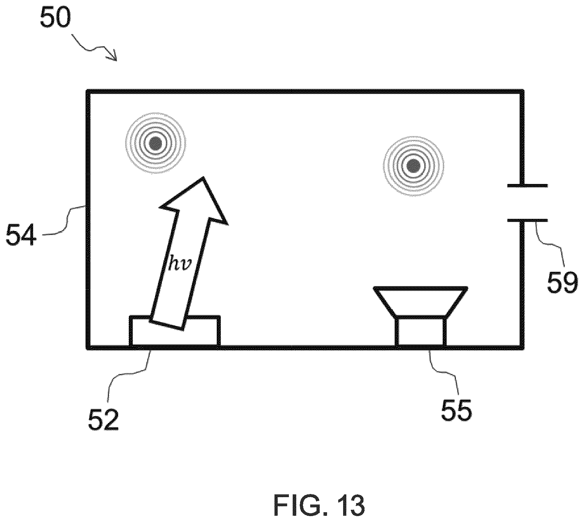

Figure 13 is a schematic drawing of an example photoacoustic gas sensor 50 incorporating a QCL (or ICL) according to an embodiment of the invention as the emitter 52. The QCL (or ICL) 52 outputs a laser beam that excites the gas present in the cell 54. A pressure wave is generated through non-radiative scattering of the molecules, as indicated schematically by the concentric circles around two example molecules. The pressure wave can be detected with an acoustic detector 56 such as a microphone or a quartz-tuning fork. The gas cell 54 may be provided with a suitable port 59 to introducing (and removing) a gas to be sensed into the gas cell 54.

A gas sensor incorporating a cascade laser as described herein may be incorporated in an Internet of Things (IoT) sensor device. The low power consumption of the cascade lasers disclosed herein means that they are suitable for battery powered operation with a long battery lifetime, e.g. several years. An IoT gas sensor device may include a battery for powering the gas sensor as well as further ancillary components such as a wireless transceiver operable to transmit the detector signal and/or the concentration of gas molecules to a remote receiver. One example commercial product is the CA-8210 transceiver chip from Cascoda Limited. Other known IoT sensor components may also be included for known functions, such as for energy harvesting to directly power the electronic components and/or recharge the battery.

It will be clear to one skilled in the art that many improvements and modifications can be made to the foregoing exemplary embodiment without departing from the scope of the present disclosure.

REFERENCES

1. M. J. Süess et al., "Single-Mode Quantum Cascade Laser Array Emitting From a Single Facet," in IEEE Photonics Technology Letters, vol. 28, no. 11, pp. 1197-1200, 1 June, 2016, (doi: https://doi.org/10.1109/LPT.2016.2533443)

2. US 2013/0016749 A1 (Mitsubishi)

3. R. Szedlak, C. Schwarzer, T. Zederbauer, H. Detz, A. Andrews, W. Schrenk, and G. Strasser, "Grating-based far field modifications of ring quantum cascade lasers," Opt. Express 22, 15829-15836 (2014) (doi: https://doi.org/10.1364/OE.22.015829)

4. Mahler, L., Tredicucci, A., Beltram, F. et al. Vertically emitting microdisk lasers. Nature Photon 3, 46-49 (2009) (doi: https://doi.org/10.1038/nphoton.2008.248)

5. G. Liang, H. Liang, Y. Zhang, L. Li, A. Davies, E. Linfield, S. Yu, H. Liu, and Q. Wang, "Low divergence single-mode surface-emitting concentric-circular-grating terahertz quantum cascade lasers," Opt. Express 21, 31872-31882 (2013) (https://doi.org/10.1364/OE.21.031872)

6. Cendejas, R. A., Liu, Z., Sanchez-Vaynshteyn, W., Caneau, C. G., Zah, C. E., & Gmachl, C. (2011). Cavity length scaling of quantum cascade lasers for single-mode emission and low heat dissipation, room temperature, continuous wave operation. IEEE Photonics Journal, 3(1), 71-81. https://doi.org/10.1109/JPHOT.2010.2103376

7. Hofling, S., Reithmaier, J. P., & Forchel, A. (2005). Device performance and wavelength tuning behavior of ultra-short quantum-cascade microlasers with deeply etched Bragg-mirrors. IEEE Journal on Selected Topics in Quantum Electronics, 11(5), 1048-1054. https://doi.org/10.1109/JSTQE.2005.853849

8. L. Hvozdara, A. Lugstein, N. Finger, S. Gianordoli, W. Schrenk, K. Unterrainer, E. Bertagnolli, G. Strasser, and E. Gornik, App. Phys. Lett. 77, 1241 (2000) (https://doi.org/10.1063/1.1289910)

9. Wang, Z., Kapsalidis, F., Wang, R., Beck, M., & Faist, J. (2021). Ultra-low threshold lasing through phase front engineering via a metallic circular aperture. https://doi.org/10.1038/s41467-021-27927-9

10. I. E. Gordon, L. S. Rothman, C. Hill, R. V. Kochanov, Y. Tan, P. F. Bernath, M. Birk, V. Boudon, A. Campargue, K. V. Chance, B. J. Drouin, J. M. Flaud, R. R. Gamache, J. T. Hodges, D. Jacquemart, V. I. Perevalov, A. Perrin, K. P. Shine, M. A. Smith, J. Tennyson, G. C. Toon, H. Tran, V. G. Tyuterev, A. Barbe, A. G. Cs'asz'ar, V. M. Devi, T. Furtenbacher, J. J. Harrison, J. M. Hartmann, A. Jolly, T. J. Johnson, T. Karman, I. Kleiner, A. A. Kyuberis, J. Loos, O. M. Lyulin, S. T. Massie, S. N. Mikhailenko, N. Moazzen-Ahmadi, H. S. Müller, O. V. Naumenko, A. V. Nikitin, O. L. Polyansky, M. Rey, M. Rotger, S. W. Sharpe, K. Sung, E. Starikova, S. A. Tashkun, J. V. Auwera, G. Wagner, J. Wilzewski, P. Wcis lo, S. Yu, and E. J. Zak. The HITRAN2016 molecular spectroscopic database, Journal of Quantitative Spectroscopy and Radiative Transfer, vol. 203, pp. 3-69, 12 2017. 5, 208

11. Popa, D., & Udrea, F. (2019). Towards integrated mid-infrared gas sensors. Sensors (Switzerland), 19(9). https://doi.org/10.3390/s19092076

12. Jouy et al Appl. Phys. Lett. 106, 071104 (2015) https://doi.org/10.1063/1.4913203

13. Wang et al, Optics Express Vol. 27, Issue 16 (2019) https://doi.org/10.1364/OE.27.022708, and

14. US 2009/147818 A1 (IBM)

15. Slivken, S., Wu, D. & Razeghi, M. Surface Emitting, Tunable, Mid-Infrared Laser with High Output Power and Stable Output Beam. Sci Rep 9, 549 (2019). https://doi.org/10.1038/s41598-018-36872-5

16. Kapsalidis, F., Shahmohammadi, M., Süess, M.J. et al. Dual-wavelength DFB quantum cascade lasers: sources for multi-species trace gas spectroscopy. Appl. Phys. B 124, 107 (2018). (https://doi.org/10.1007/s00340-018-6973-2)

17. Wu, D. H., Razeghi, M. High power, low divergent, substrate emitting quantum cascade ring laser in continuous wave operation. APL Materials 5, 035505 (2017). (https://doi.org/10.1063/1.4978810)

18. US 2019/074663 A1 (Toshiba)

19. Olmon, Slovick, Johnson, Shelton, Oh, Boreman and Raschke "Optical dielectric function of gold" Phys. Rev. B 86, 235147

20. D. I. Babic and S. W. Corzine, "Analytic expressions for the reflection delay, penetration depth, and absorptance of quarter-wave dielectric mirrors," in IEEE Journal of Quantum Electronics, vol. 28, no. 2, pp. 514-524, Feb. 1992, doi: 10.1109/3.123281.

21. Elsa Garmire, "Theory of quarter-wave-stack dielectric mirrors used in a thin Fabry-Perot filter," Appl. Opt. 42, 5442-5449 (2003)

**Claims**

1. A single-mode cascade laser with a lasing wavelength that lies in the wavelength range 2 to 20 micrometers, the laser comprising:

   a plurality of semiconductor layers collectively forming an active region where gain can occur across a gain bandwidth that includes the lasing wavelength;
   a waveguide encompassing the active region and terminating in first and second end facets; and
   respective end mirrors formed on the end facets of the waveguide, each end mirror comprising a layer of a first optical material formed on its respective waveguide end facet and a layer of a second optical material formed on the first optical material layer, the first and second optical materials having different refractive indices at the lasing wavelength,
   wherein the waveguide and the end mirrors collectively form a Fabry-Perot cavity with a cavity length that provides a longitudinal mode in the waveguide with an energy at the lasing wavelength,
   wherein the end mirrors both have a reflectivity of at least 90% for the lasing longitudinal mode, and
   wherein the cavity length is equal to or less than 100 micrometres.

2. The laser of claim 1, wherein, for one or both of the end mirrors, the first optical material is a dielectric and the second optical material is a metal.

3. The laser of claim 2, wherein the first optical material layer has a physical thickness of between 0.2 and 1.3 times one-quarter of the lasing wavelength within the first optical material, more particularly between 0.3 and 1.2 times one-quarter of the lasing wavelength.

4. The laser of claim 1, wherein, for one or both of the end mirrors, the first and second optical materials are both dielectrics.

5. The laser of claim 4, wherein the or each dielectric-dielectric end mirror comprises at least two repeats of the first and second optical material layers, each of the first and second optical material layers having a physical thickness of between 0.7 and 1.3 times one-quarter of the lasing wavelength within the first and second optical materials, more particularly between 0.8 and 1.2 times one-quarter of the lasing wavelength.

6. The laser of any preceding claim, further comprising a surface extractor component for coupling out light at the lasing wavelength out of the plane of the waveguide.

7. The laser of claim 6, wherein the surface extractor component is a higher order Bragg grating formed along a portion of the waveguide.

8. The laser of any preceding claim, wherein one or both of the end mirrors has a reflectivity of at least one of: 91%, 92%, 93%, 94%, 95%, 96%, 97% and 98% for the lasing longitudinal mode.

9. The laser of any preceding claim, wherein, when operating at an optical output power of one of 0.5 mW and 1 mW, the laser has a side-mode suppression ratio of greater than 30 decibels.

10. The laser of any preceding claim, wherein the waveguide end facets are formed through dry etching.

11. The laser of any preceding claim, wherein the first and second optical material layers are coatings deposited on their associated waveguide end facet.

12. The laser of any preceding claim, wherein the cavity length is between one of 100, 90, 80, 70 and 60 micrometres and one of 10, 20, 30, 40 and 50 micrometres.

13. The laser of any preceding claim, wherein the laser is one of a quantum cascade laser and an interband cascade laser.

14. A method of manufacturing a single-mode cascade laser that will operate with a specified lasing wavelength $\lambda$, the specified lasing wavelength lying in the wavelength range 2 to 20 micrometers, the method comprising:

providing a semiconductor wafer with a plurality of semiconductor layers collectively forming an active region where gain can occur across a gain bandwidth that includes the specified lasing wavelength;
fabricating a waveguide that encompasses the active region;
fabricating first and second end facets for the waveguide by dry etching so that the waveguide has a length equal to a specified physical length $L_{phys}$;
forming respective end mirrors on the waveguide end facets, the end mirrors having respective effective thicknesses $L_{coat1}$, $L_{coat2}$, each end mirror comprising a layer of a first optical material formed on its respective waveguide end facet and a layer of a second optical material formed on the first optical material layer, the first and second optical materials having different refractive indices at the specified lasing wavelength, wherein the first and second end mirrors each provide a reflectivity of at least 90% for the lasing longitudinal mode,
wherein the waveguide and end mirrors collectively form a Fabry-Perot cavity with a cavity length expressed by the formula

$$L_{tot} = L_{phys} \cdot n_{refr} + L_{coat1} + L_{coat2} = q \cdot \frac{\lambda}{2},$$

where $q$ is an integer and $n_{refr}$ is the effective refractive index of the waveguide at the specified lasing wavelength, and wherein the cavity length is equal to or less than 100 micrometres.

**15.** A method of computing a set of parameter values for manufacturing a single-mode cascade laser that will lase at a specified lasing wavelength $\lambda$, the specified lasing wavelength lying in the wavelength range 2 to 20 micrometers, the method comprising:

receiving as input specifications for a semiconductor wafer with a plurality of semiconductor layers collectively forming an active region where gain can occur across a gain bandwidth that includes the specified lasing wavelength;

receiving as input specifications for a waveguide that encompasses the active region including a value for the effective refractive index $n_{refr}$ of the waveguide at the specified lasing wavelength;

selecting a cavity length for a Fabry-Perot cavity that complies with the formula

$$L_{tot} = q \cdot \frac{\lambda}{2},$$

where q is an integer and which is equal to or less than 100 micrometres;

determining respective effective thicknesses $L_{coat1}$, $L_{coat2}$ for for respective end mirrors, each end mirror comprising a layer of a first optical material formed on its respective waveguide end facet and a layer of a second optical material formed on the first optical material layer, the first and second optical materials having different refractive indices at the lasing wavelength;

determining a physical length $L_{phys}$ for the waveguide according to the formula

$$L_{tot} = L_{phys} \cdot n_{refr} + L_{coat1} + L_{coat2} = q \cdot \frac{\lambda}{2} \quad ;$$

and

outputting as the set of parameters values the determined physical length $L_{phys}$ of the waveguide and the determined effective thicknesses $L_{coat1}$, $L_{coat2}$ for the end mirrors.

FIG. 1

FIG. 2

FIG. 3

FIG. 4A

FIG. 4B

FIG. 4C

**FIG. 5A**

FIG. 5B

FIG. 6A

FIG. 6B

FIG. 6C

FIG. 6D

FIG. 6E

FIG. 6F

FIG. 7A

FIG. 7B

FIG. 8A

FIG. 8B

FIG. 8C

FIG. 9

FIG. 10A

FIG. 10B

FIG. 11

FIG. 12

FIG. 13

Europäisches
Patentamt

European
Patent Office

Office européen
des brevets

# EUROPEAN SEARCH REPORT

Application Number

EP 22 16 6290

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | CENDEJAS R A ET AL: "Cavity Length Scaling of Quantum Cascade Lasers for Single-Mode Emission and Low Heat Dissipation, Room Temperature, Continuous Wave Operation", IEEE PHOTONICS JOURNAL, IEEE, USA, vol. 3, no. 1, 1 February 2011 (2011-02-01), pages 71-81, XP011485038, ISSN: 1943-0655, DOI: 10.1109/JPHOT.2010.2103376 | 15 | INV. H01S5/34 H01S5/10 ADD. H01S5/028 H01S5/00 |
| A | * pages 71-77; figures 1,3-6,11 * | 1-14 | |
| X | US 2012/134380 A1 (EDAMURA TADATAKA [JP] ET AL) 31 May 2012 (2012-05-31) | 15 | |
| A | * paragraphs [0041] - [0064]; figures 3,4 * * paragraphs [0067] - [0073]; figures 8,9 * | 1-14 | |
| X | CN 101 662 124 A (INST SEMICONDUCTORS CAS) 3 March 2010 (2010-03-03) | 15 | TECHNICAL FIELDS SEARCHED (IPC) |
| A | * page 5; figure 1 * | 1,14 | H01S |
| X,D | GARMIRE ELSA: "Theory of quarter-wave-stack dielectric mirrors used in a thin Fabry-Perot filter", APPLIED OPTICS, vol. 42, no. 27, 20 September 2003 (2003-09-20), pages 5442-4040, XP055961345, US ISSN: 0003-6935, DOI: 10.1364/AO.42.005442 * the whole document * * equations 1, 4, 28 * | 15 | |

The present search report has been drawn up for all claims

| Place of search | Date of completion of the search | Examiner |
|---|---|---|
| Munich | 16 September 2022 | Riechel, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 16 6290

This annex lists the patent family members relating to the patent documents cited in the above-mentioned European search report.
The members are as contained in the European Patent Office EDP file on
The European Patent Office is in no way liable for these particulars which are merely given for the purpose of information.

16-09-2022

| Patent document cited in search report | | Publication date | Patent family member(s) | | Publication date |
|---|---|---|---|---|---|
| US 2012134380 | A1 | 31-05-2012 | JP | 2012129497 A | 05-07-2012 |
| | | | US | 2012134380 A1 | 31-05-2012 |
| CN 101662124 | A | 03-03-2010 | NONE | | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2009147818 A1
- US 20130016749 A1
- US 2019074663 A1

**Non-patent literature cited in the description**

- **M. J. SÜESS et al.** Single-Mode Quantum Cascade Laser Array Emitting From a Single Facet. *IEEE Photonics Technology Letters,* 01 June 2016, vol. 28 (11), 1197-1200, https://doi.org/10.1109/LPT.2016.2533443
- **R. SZEDLAK ; C. SCHWARZER ; T. ZEDERBAUER ; H. DETZ ; A. ANDREWS ; W. SCHRENK ; G. STRASSER.** Grating-based far field modifications of ring quantum cascade lasers. *Opt. Express,* 2014, vol. 22, 15829-15836, https://doi.org/10.1364/OE.22.015829
- **MAHLER, L. ; TREDICUCCI, A. ; BELTRAM, F. et al.** Vertically emitting microdisk lasers. *Nature Photon,* 2009, vol. 3, 46-49, https://doi.org/10.1038/nphoton.2008.248
- **G. LIANG ; H. LIANG ; Y. ZHANG ; L. LI ; A. DAVIES ; E. LINFIELD ; S. YU ; H. LIU ; Q. WANG.** Low divergence single-mode surface-emitting concentric-circular-grating terahertz quantum cascade lasers. *Opt. Express,* 2013, vol. 21, 31872-31882, https://doi.org/10.1364/OE.21.031872
- **CENDEJAS, R. A. ; LIU, Z. ; SANCHEZ-VAYNSHTEYN, W. ; CANEAU, C. G. ; ZAH, C. E. ; GMACHL, C.** Cavity length scaling of quantum cascade lasers for single-mode emission and low heat dissipation, room temperature, continuous wave operation. *IEEE Photonics Journal,* 2011, vol. 3 (1), 71-81, https://doi.org/10.1109/JPHOT.2010.2103376
- **HOFLING, S. ; REITHMAIER, J. P ; FORCHEL, A.** Device performance and wavelength tuning behavior of ultra-short quantum-cascade microlasers with deeply etched Bragg-mirrors. *IEEE Journal on Selected Topics in Quantum Electronics,* 2005, vol. 11 (5), 1048-1054, https://doi.org/10.1109/JSTQE.2005.853849
- **L. HVOZDARA ; A. LUGSTEIN ; N. FINGER ; S. GIANORDOLI ; W. SCHRENK ; K. UNTERRAINER ; E. BERTAGNOLLI ; G. STRASSER ; E. GORNIK.** *App. Phys. Lett.,* 2000, vol. 77, 1241, https://doi.org/10.1063/1.1289910

- **WANG, Z. ; KAPSALIDIS, F. ; WANG, R. ; BECK, M. ; FAIST, J.** *Ultra-low threshold lasing through phase front engineering via a metallic circular aperture,* 2021, https://doi.org/10.1038/s41467-021-27927-9
- **I. E. GORDON ; L. S. ROTHMAN ; C. HILL ; R. V. KOCHANOV ; Y. TAN ; P. F. BERNATH ; M. BIRK ; V. BOUDON ; A. CAMPARGUE ; K. V. CHANCE.** The HITRAN2016 molecular spectroscopic database. *Journal of Quantitative Spectroscopy and Radiative Transfer,* December 2017, vol. 203, 3-69
- **POPA, D. ; UDREA, F.** Towards integrated mid-infrared gas sensors. *Sensors (Switzerland),* 2019, vol. 19 (9, https://doi.org/10.3390/s19092076
- **JOUY et al.** *Appl. Phys. Lett.,* 2015, vol. 106, 071104, https://doi.org/10.1063/1.4913203
- **WANG et al.** *Optics Express,* 2019, vol. 27 (16, https://doi.org/10.1364/OE.27.022708
- **SLIVKEN, S. ; WU, D. ; RAZEGHI, M.** Surface Emitting, Tunable, Mid-Infrared Laser with High Output Power and Stable Output Beam. *Sci Rep,* 2019, vol. 9, 549, https://doi.org/10.1038/s41598-018-36872-5
- **KAPSALIDIS, F. ; SHAHMOHAMMADI, M. ; SÜESS, M.J. et al.** Dual-wavelength DFB quantum cascade lasers: sources for multi-species trace gas spectroscopy. *Appl. Phys. B,* 2018, vol. 124, 107, https://doi.org/10.1007/s00340-018-6973-2
- **WU, D. H. ; RAZEGHI, M.** High power, low divergent, substrate emitting quantum cascade ring laser in continuous wave operation. *APL Materials,* 2017, vol. 5, 035505, https://doi.org/10.1063/1.4978810
- **OLMON ; SLOVICK ; JOHNSON ; SHELTON ; OH ; BOREMAN ; RASCHKE.** Optical dielectric function of gold. *Phys. Rev. B,* vol. 86, 235147
- **D. I. BABIC ; S. W. CORZINE.** Analytic expressions for the reflection delay, penetration depth, and absorptance of quarter-wave dielectric mirrors. *IEEE Journal of Quantum Electronics,* February 1992, vol. 28 (2), 514-524

- **ELSA GARMIRE.** Theory of quarter-wave-stack dielectric mirrors used in a thin Fabry-Perot filter. *Appl. Opt.,* 2003, vol. 42, 5442-5449

- **ELSA GARMIRE.** Theory of quarter-wave-stack dielectric mirrors used in a thin Fabry-Perot filter. *Appl. Opt.,* 2003, vol. 42, 5442-5449